# EUROPEAN PATENT SPECIFICATION

(11) **EP 4 104 117 B1**
(45) Date of publication and mention of the grant of the patent: **28.10.2026**
(21) Application number: 21704481.7
(22) Date of filing: 08.02.2021
(51) Int. Cl.: G05B 17/02, G06Q 10/04, G06Q 10/20, G06Q 10/0635, G06Q 50/40

(54) **DIGITAL PLATFORM USING CYBER-PHYSICAL TWIN STRUCTURES PROVIDING AN EVOLVING DIGITAL REPRESENTATION OF A REAL WORLD ASSET FOR QUANTIFYING EVENT OCCURRENCES MEASUREMENTS, AND METHOD THEREOF**
DIGITALE PLATTFORM UNTER VERWENDUNG VON CYBER-PHYSISCHEN ZWILLINGSSTRUKTUREN ZUR BEREITSTELLUNG EINER SICH ENTWICKELNDEN DIGITALEN DARSTELLUNG EINES REALEN WERTES ZUR QUANTIFIZIERUNG VON EREIGNISAUFTRITTSMESSUNGEN
PLATEFORME NUMÉRIQUE UTILISANT DES STRUCTURES JUMELLES CYBERPHYSIQUES FOURNISSANT UNE REPRÉSENTATION NUMÉRIQUE ÉVOLUTIVE D'UN ACTIF DU MONDE RÉEL POUR QUANTIFIER DES MESURES D'APPARITIONS D'ÉVÉNEMENTS, ET PROCÉDÉ ASSOCIÉ

(30) Priority: 12.02.2020 WO PCT/EP2020/053646
(43) Date of publication of application: 21.12.2022
(73) Proprietor: Swiss Reinsurance Company Ltd., 8022 Zürich (CH)
(72) Inventor: FASANO, Pierluigi, 1112 Echichens (CH)
(74) Representative: Leimgruber, Fabian Alfred Rupert
(86) International application number: PCT/EP2021/052955
(87) International publication number: WO 2021/160558

(56) References cited:
- US-A1- 2017 323 240
- US-A1- 2018 054 376

## Description

### Field of the Invention

The present invention relates to a digital-based system for avatar measurements based on evolving real-world measuring parameters. In particular, it relates to a digital system operating based on versatile digital avatars providing exact replicas or digital twins of physical objects and processes. Such systems are used to operate complex products and processes as cyber-physical manufacturing systems or therapeutic systems in the field of precise personalized and predictive medicine. More particular, the invention relates to digital systems proliferatingly using avatar measurements in the context of the Internet of Things (IoT) and machine learning technologies.

### Background of the Invention

In all fields of technology, it is often a requirement to make assessment and/or predictions regarding the evolving operation or status of real world physical systems, assets or living objects, such as electro-mechanical systems, product processing systems, time characteristics and temporal behavior of buildings and constructions, or human beings or animals based on measured parameters and sensory data, for example for cyber-physical manufacturing, precise personalized and predictive medicine (e.g. telematics based), floating short or long scale risk assessment and measurements of physical real-world assets, or augmented or mixed reality technologies. For example, it may be desirable to automatically predict a remaining useful life of a technical system operatable within an acceptable failure risk, such as an aircraft engine, to help plan when the system should be replaced. Further, an operator of a system or physical asset may want to monitor a condition or a portion of the system or physical asset, to allow for conducting proper technical maintenance, etc. However, despite the improvements in sensor and computer technologies, accurately making such risk assessments and/or predictions is still a difficult technical task. For example, an event that occurs while a system or physical asset is not operating may also impact the remaining useful life and/or condition of the system or asset but are not taken into account by typical approaches in the prior art.

A real world physical system can be associated with asset's or system's components, such as sensors and actuators. Example of these are smart homes or Advance Driver Assistance Systems (ADAS) of cars. The monitored systems and assets can be spatially distributed and, thus, these systems and assets include components and subsystems that are also spatially distributed. As a consequence, there may be a need to provide an appropriate information transportation and distribution that serves to sense and transmit measuring parameter values and data, and control the spatially distributed components and subsystems in order for the system or asset to function efficiently and safely. In the state of the art, despite the fact that loT provides a new dimension of connectivity, there is still a great need for systems and technologies that provides connectivity and computational intelligence for the system's components that are connected to the loT. It is therefore a demand to provide technical systems and methods to allow technical assessments and/or automated predictions and forecasts for physical systems e.g. associated with the loT in an automatic and technically precise manner relying on measured physical parameters.

Another technical problem to provide such systems is, that the number of factors and parameters to monitor, assess and/or monitor e.g. for securing maintenance and/or to operate real world physical or intangible assets or objects as e.g. large, complex industrial systems and their associated apparatuses such as engines or product processing devices etc., or to continuously monitor physical medical condition parameters of living objects such as human beings or animals, in particular for interventions and optimization based on such factors (for example for asset utilization, consumption reduction, preventive measures, physical inspections, physical damage state assessment work-scope, and operation capacity etc.) is often that large that it has to be performed in nature and in loco and is time-consuming and technically complex. Thus, it is another requirement to provide technical systems and methods to allow technical assessments and/or automated predictions and forecasts for the evolution of physical systems.

Finally, the machine-based prediction or forecast of occurrence probabilities for events causing impacts, i.e. occurring risks, is technically difficult to be realized because of their long-tail nature and their susceptibility to measuring and parametrizing quantitative impact factors and to capturing temporal time developments and parameter fluctuations. Automation of prediction and modeling of catastrophes and risk accumulation is especially challenging as there is limited historic loss data available, and new risk events with new characteristics keep emerging. In addition to finding, triggering and/or mitigating valuable loss and exposure data where existing, it is therefore important to reduce the reliance on historic data by using novel modelling techniques going beyond traditional data analysis and predictive modeling approaches and techniques by monitoring a controllable cause-effect chain. Risk driven systems have been developed and used triggered and signaled by automated forecast systems. Such systems are able to predictively and quantitatively generate expected occurrence probability of physical events and their impact such as losses to physical assets and objects typically starting from a set of modelling scenarios, which heavily depend in their timely development on the modelling technique. So there is a further requirement, to provide a new technical system to overcome these problems.

Digital representations (avatars) of twinned physical real-world assets and objects are herein referred as digital twins, i.e. an evolving digital data representation of a historical and current behavior of the twinned physical real-world asset and object or process. Thus, a digital representation of twinned physical real-world asset and object is the exact digital replica of the twinned physical real-world asset and object. The resulting digital avatar allows directly linking modelling structures and simulation techniques with sensors and big data. For example, the digital twin of an automobile is a digital, 3D representation of every part of the vehicle, technically replicating the physical world so accurately that a human could virtually operate the vehicle exactly as she/he would in the physical world and get the same responses, digitally simulated. It is to be noted, that in this applications, physical assets may also refer to physical processes, which are digitally twinned. Further, in this application, the sophisticate digital twins may continuously pull real-time sensor and systems data to provide precise snapshots of the physical twin's current state. These data can then be integrated with historical data and predictive technologies allowing to provide signals related to potential issues and/or trigger the indication of solutions. The inventive solution of this application based on the provided digital risk twin technology can profoundly enhance the ability to make or trigger proactive, measuring data-driven decisions, increasing efficiency and avoiding potential issues by reducing the risk measure provided by the inventive system. In fact, the invention enables to explore possible futures by exploring what-if scenarios based on the current measuring state of the asset of object and the evolving state of the digital avatar representation.

In the prior art, US 2017/0323240 A1 discloses such a system providing an digital data representation of a historical and current behavior of the twinned physical real-world asset and object or process. In particular, US 2017/0323240 A1 discloses a system for aircraft optimized maintenance and operation, even more particularly, for dynamic optimization of operation related specific factors of an aircraft engine systems (or an industrial asset) in the present to achieve constrained state estimation objectives or constraints of an operator or original equipment manufacturer (OEM). Such operation related specific factors are e.g. asset utilization factors, fuel cost reduction, physical inspection periodicity, physical damage state assessment, work scope, and shop service capacity factors. A digital twins are generated for the industrial asset. The digital twin include data structures representing states of each of a plurality of subsystems of the industrial asset over a time period based on an application of simulations using damage models. The damage models modeling the effects of exogenous factors on the operation of the set of industrial assets over a defined, measuring time period. Based on an uncertainty level of at least one of the estimated states transgressing an uncertainty threshold, actual state data is requested from an inspection system of the industrial asset. Based on the received actual state data, the data structures are updated to include the actual state data. The uncertainty level of the estimated states of each of the plurality of subsystems is also updated. The digital twins are continuously analyzed to determine a recommendation pertaining to operation of the industrial assets. Further, US 2018/0054376 A1 discloses providing a data structure to facilitate the implementation of a digital twin of a twinned physical system, in particular electro-mechanical systems such as aircraft engines. The system allows to determine operational parameters of the twinned systems as e.g. Remaining Useful Life (RUL) of the electro-mechanical system helping to plan when the aircraft engine should be replaced. Using the digital twin representation, the system also allows to monitor a specific condition of the system to help make maintenance decisions, and appropriate budget allocations, etc.

### Summary of the Invention

It is an object of the invention to allow for systematic capturing, measuring, quantifying, and forward-looking generating of appropriate risk and risk accumulation measures of physical real-world assets and objects based on physical measuring parameter values and data. Further, the system should be able to connect directly to the core flow of data of the present digital society e.g. using wearables, quantified-self, Internet of Things, smart cities, and industry 4.0 technologies, etc.) by providing a new technology for automated digital risk assessment and forecasting platforms. It is a further object of the invention to allow ensuring the accumulation of quality data which is critical for understanding, identifying, and developing more precise technical instruments and systems to monitor and assess occurrence probabilities and events risks in the age of big data, industry 4.0 and broad mobile internet connectivity e.g. 5G data networks, where the increased bandwidth enables machines, robots and other assets or objects with a high sensory environment, as smart homes and smart cities to collect and transfer more data than ever. The invention should thus be scalable, and the used simulation technics should be easily accessible to the physical assets' analytics. The invention should in particular allow for a normalization of the used risk factors and measuring values. Further, the invention should be easily integratable in other processes, productions chains or risk assessment and measuring systems. Finally, the invention should be enabled to use data and measuring parameter values from multiple heterogeneous data sources, inter alia from loT sensory. The probability measures and risk forecasts should allow to capture various device and environmental structures, providing a precise and reproducible measuring of risk factors, and allowing to optimize associated event occurrence impacts of the captured risk events.

The invention is defined by the method of claim 1 and by the apparatus of claim 11. Optional aspects of the invention are provided by the dependent claims.

According to the present invention, the abovementioned objects are particularly achieved by the digital platform for avatar measurements of evolving risk-based real-world measuring parameters, the digital platform comprising at least one input device or measuring sensor associated with a specific physical or intangible real-world asset or living object to be monitored, in that the digital platform comprises a data store storing modular digital assets/objects elements each representing a plurality of subsystems of the real-world asset or object for the assembly of a digital twin representation of the physical or intangible real-world assets or living objects, wherein the modular digital assets or objects elements are selectable to be assembled to said digital twin representation from the data store based on captured structural, operational and/or environmental parameters by means of the digital platform, in that by means of the at least one input device or sensor associated with the twinned physical asset or object, structural, operational and/or environmental status parameters of the real-world asset or object are measurable, and transmittable to the digital platform, to be associated to the digital twin representation, wherein the values of the status parameters associated with the digital twin representation are dynamically monitored and adapted based on the transmitted parameters, and wherein the digital twin representation comprises data structures representing states of each of the plurality of subsystems of the real-world asset or object holding the parameter values as a time series of a time period, in that, by means of the digital platform, data structures representing future states of each of the plurality of subsystems of the real-world asset or object are generatable as value time series over a future time period based on an application of simulations using cumulative damage models, the cumulative damage models generating the effect of the operational and/or environmental asset or object parameters on the twinned real-world asset or object of the future time period, and in that, by means of the digital platform, the digital twin representation is analyzable providing a measure for a future state or operation of the twinned real-world asset or object based on the generated value time series of values over said future time period, the measure being related to the probability of the occurrence of a predefined event to the real-world asset or object.

In an embodiment variant, the control of an operation or status of the real world asset or object is optimized or adjusted to predefined operational and/or status asset or object parameters of the specific real-world asset or object based on the provided measure for a future state or operation of the twinned real-world asset or object and/or based on the generated value time series of values over said future time period, wherein in case of an optimized control of operation, the optimized control of operation is generated to jointly and severally increase the specific operating performance criteria in time and future of the real-world asset or object or decrease a measure for an occurrence probability associated with the operation or status of the real-world asset or object within a specified probability range.

Further, the decrease of the measure for an occurrence probability associated with the operation or status of the real-world asset or object can be based on a transfer of risk to an automated risk-transfer system controlled by the digital platform, wherein values of parameters characterizing the transfer of risk are optimized based on said measure for a future state or operation of the twinned real-world asset or object and/or based on the generated value time series of values over said future time period. In order to optimize the status of the real-world asset or object or the probability of an occurrence of a predefined risk event, an optimizing adjustment of at least a subsystem of the real-world asset of object can be triggered by means of the digital platform. The triggering by means of the digital platform can e.g. be performed by electronic signal transfer. Based on the measure for a future state or operation of the twinned real-world asset or object, a forecasted measure of an occurrence probability of one or more predefined risk events impacting the real-world asset or object can be generated by propagating the parameters of the digital twin representation in controlled time series.

As a further embodiment variant, the operational and/or environmental parameters can e.g. comprise endogen parameters, whose values are determined by the real-world asset or object, and/or exogen parameters, whose values origin from and are determined outside the real-world asset or object and are imposed on the real-world asset or object. The digital platform can e.g. comprise associated exteroceptive sensors or measuring devices for sensing exogen environmental parameters physically impacting the real-world asset or object and proprioceptive sensors or measuring devices for sensing endogen operating or status parameters of the real-world asset or object. The sensors or measuring devices can e.g. comprise interfaces for setting one or more wireless or wired connections between the digital platform and the sensors or measuring devices, wherein data links are settable by means of the wireless or wired connections between the digital platform and the sensors or measuring devices associated with the real-world asset or object transmitting the exogen and endogen parameters measured and/or captured by the sensors or measuring devices to the digital platform.

As another embodiment variant, the digital platform can e.g. comprise and trigger an automated expert system of the digital platform by means of electronic signal transfer, wherein the digital platform triggers the transmission of a digital recommendation to a user interface generated by the expert system of the digital platform based on the measured value of the measure for a future state or operation of the twinned real-world asset or object and/or the measured probability of the occurrence of a predefined physical event to the real-world asset or object, and wherein the digital recommendation comprises indications for an optimization of the real-world asset or object or adaption of the structural, operational and/or environmental parameters.

### Brief Description of the Drawings

The present invention will be explained in more detail below relying on examples and with reference to these drawings in which:

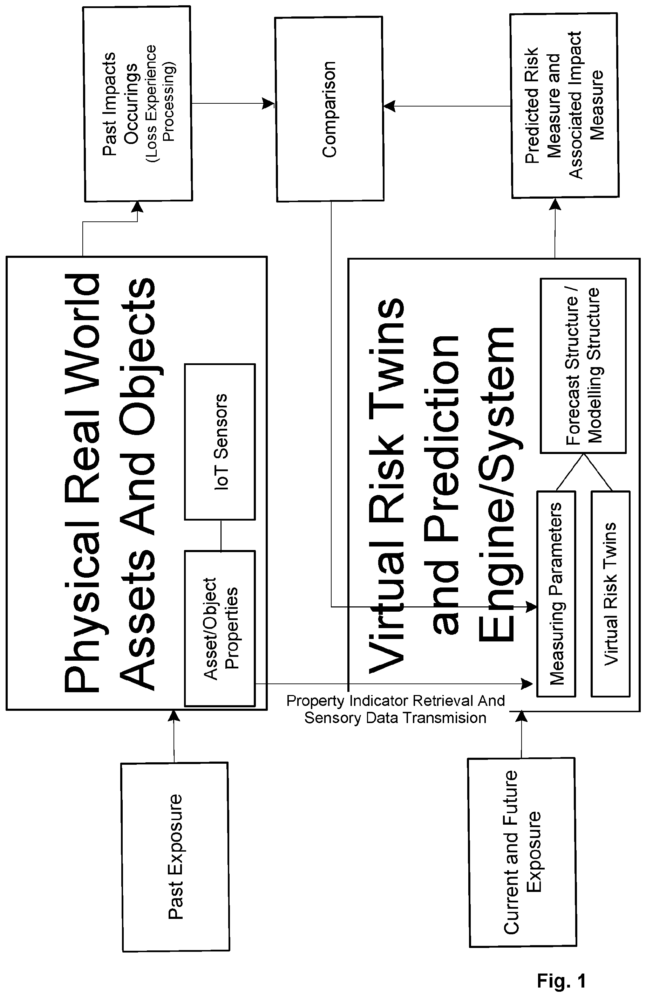

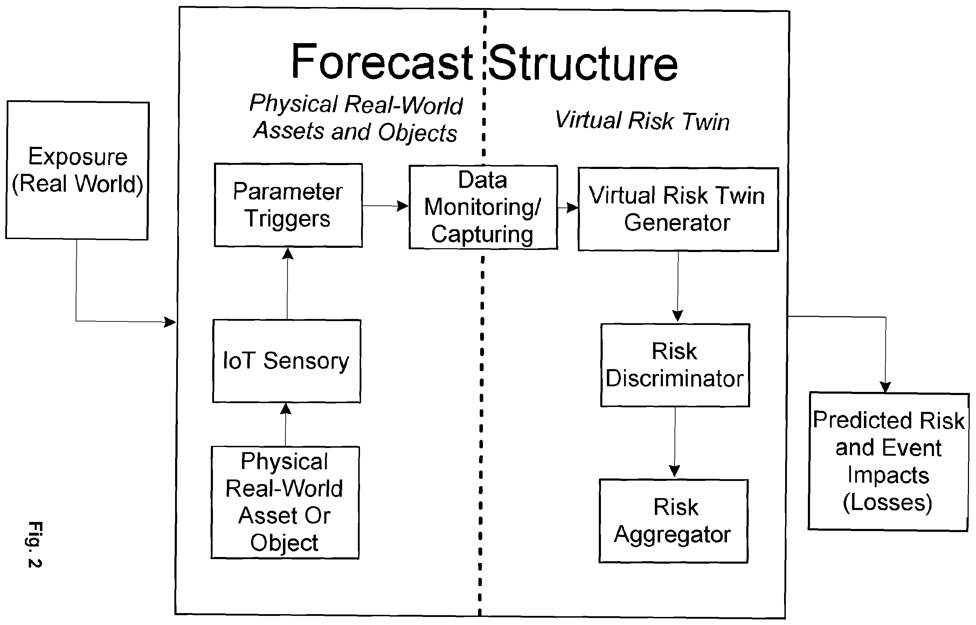

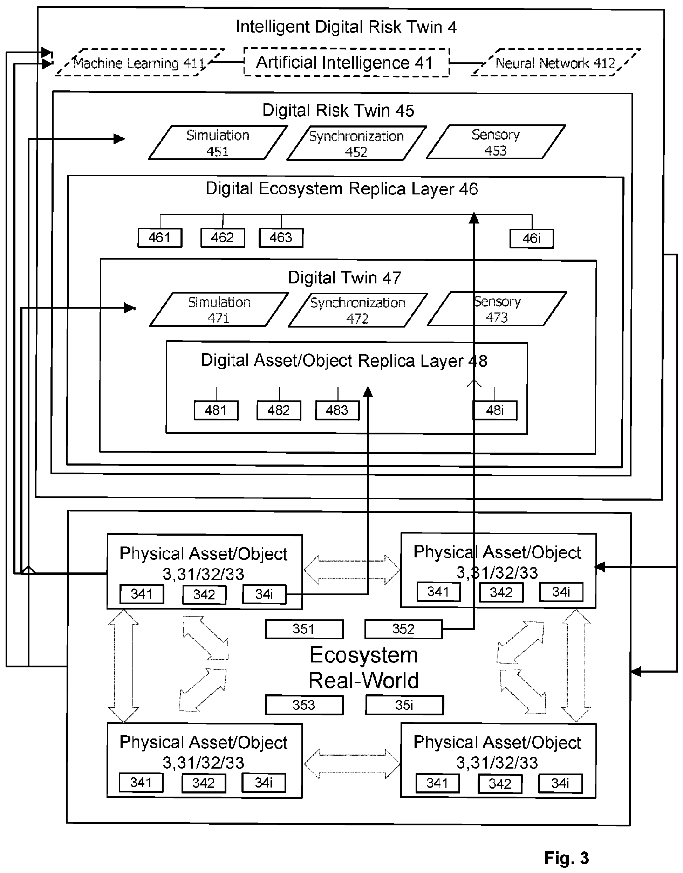

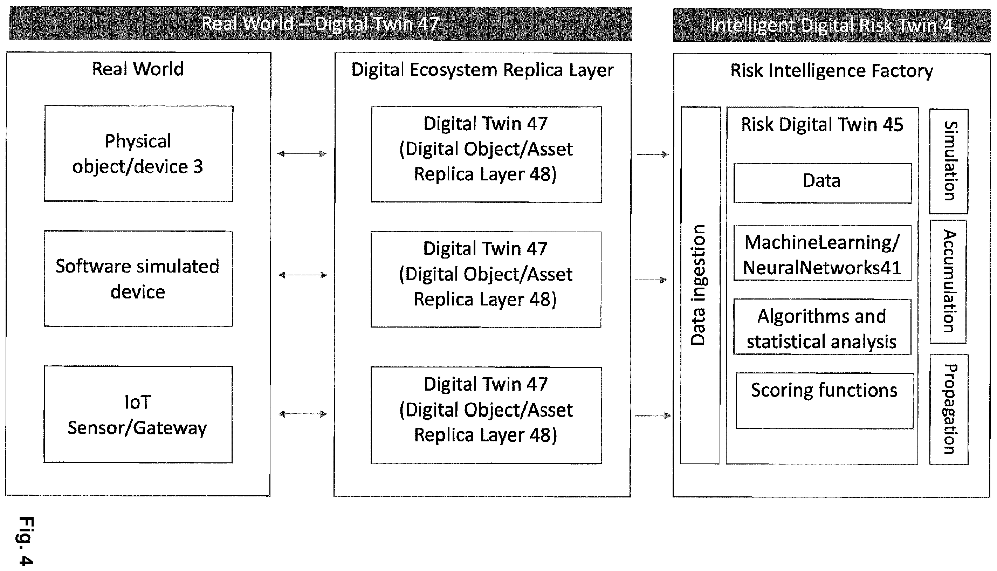

Figures 1 and 2 show block diagrams, schematically illustrating the basic structure comprising three main parts: the predicting digital risk twin structure, the properties indicator retrieval and the impact experience processing. The virtual risk twin structure allows to forecast quantitative risk measures and expected impact/loss measures from the digital risk twins using characteristic technical main elements, namely the digital risk twin structure with the simulation and synchronization means and the loT sensory providing the constant real-world streaming linkage and connection (c.f. figures 3 and 4).
Figures 3 and 4 show block diagrams illustrating schematically an exemplary digital risk twin, which can be made available throughout the entire lifecycle of the real-world asset 31/32 or object 33 and/or digital platform 1 through its structure, as shown in Fig. 3 and 4. Figure 3 shows the digital asset/object replica 48, the digital twin 47, the digital ecosystem replica 46, the digital risk robot 46 and the digital twin 4 with its optional artificial intelligence 45 of a physical entity 3 in the inventive digital platform 1. In the digital platform 1 and digital twin 47, respectively, each physical asset/object 3 comprise its digital modelling structures 481, 482, 483,..., 48i and data. These modelling structures 481, 482, 483,..., 48i and data combined form a digital asset/object replica 48 of an asset/object 3. The digital asset/object replica 48 is then equipped with the three characteristics (1) simulation 471, (2) synchronization 472 with the physical asset/object 3, (3) active data acquisition 473, to form the digital twin 47. The digital risk twin 4 consist of all characteristics of the digital twin 47 as well as a digital risk robot 45 layer and optionally the artificial intelligence layer 41 to realize an autonomous digital platform 1. The digital risk robot 45 layer consists of its own digital modelling structures 461, 462, 463,..., 46i and data, where these modelling structures 461, 462, 483,..., 46i and data combined form a digital ecosystem replica 48 of the ecosystem 5 comprising the environmental interacting factors/entities and the interaction to other real-world assets/objects 3. The digital risk twin 4, realized as an intelligent digital risk twin, can therefore implement machine learning algorithms on available models and data of the digital twin 47 and the digital risk robot 45 to optimize operation as well as continuously test what-if-scenarios, used for predictive maintenance and an overall more flexible and efficient production through plug and produce scenarios. Having an intelligent digital risk twin 4 expands the digital risk robot 45 with self-x capabilities such as selflearning or self-healing, facilitating its inner data management as well as its autonomous communication with other digital risk twins 4.

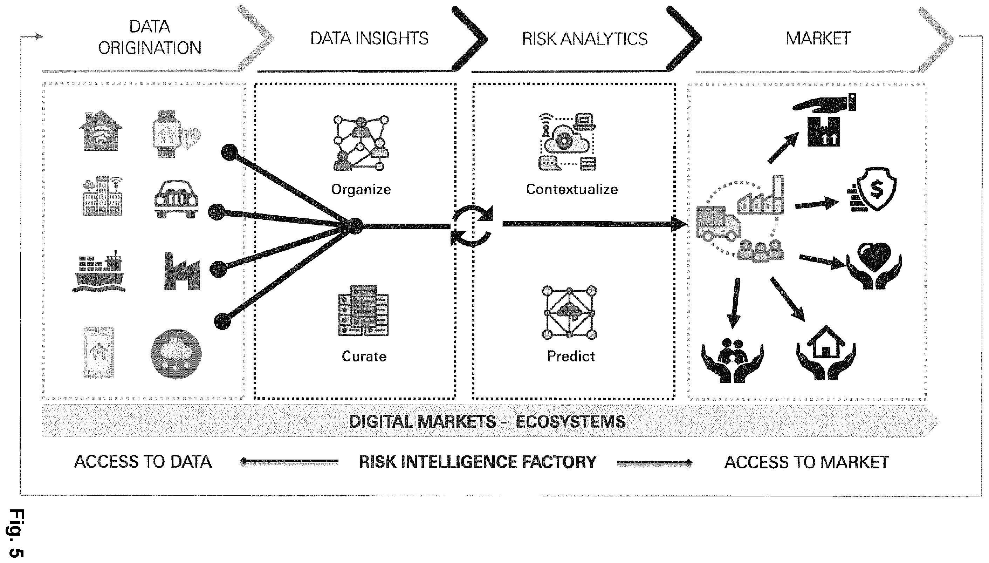

Figure 5 shows a block diagram illustrating schematically an exemplary value data chain connecting directly to the core flow of data of the digital society (wearables, quantified-self, Internet of things, smart cities, industry 4.0, etc.). The process simplifies risk-transfer technology and extend it with the inventive digital risk twin structure integrated in the digital platform to help the ecosystem understand, measure, prevent and mitigate risks end to end. The digital risk twin structure (indicators, analytics) can be embedded into digital platforms or provided directly through API.

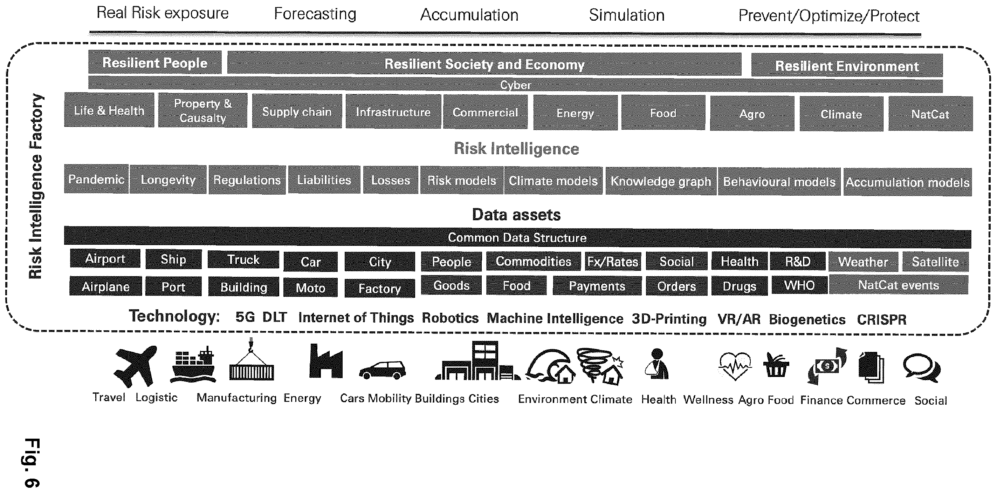

Figure 6 shows a block diagram illustrating schematically an exemplary realization of the inventive digital risk twin based platform. According to the invention, the digital representation of the risks related to a specific real world asset or object. The invention provides a quantification of risks by appropriate risk measures. This includes risk assessment and risk scoring capabilities. It can also include risk impact measures on a much larger scale (i.e. engine > plant > supply chain). The inventive solution is scalable and can be digitally created/managed. It allows to extend prior technologies for risk based data services and to create easy access to asset related insights/analytics. Further, it provides a normalized use of risk factors and values. Finally, it can be easily integrated in other processes/value chains.

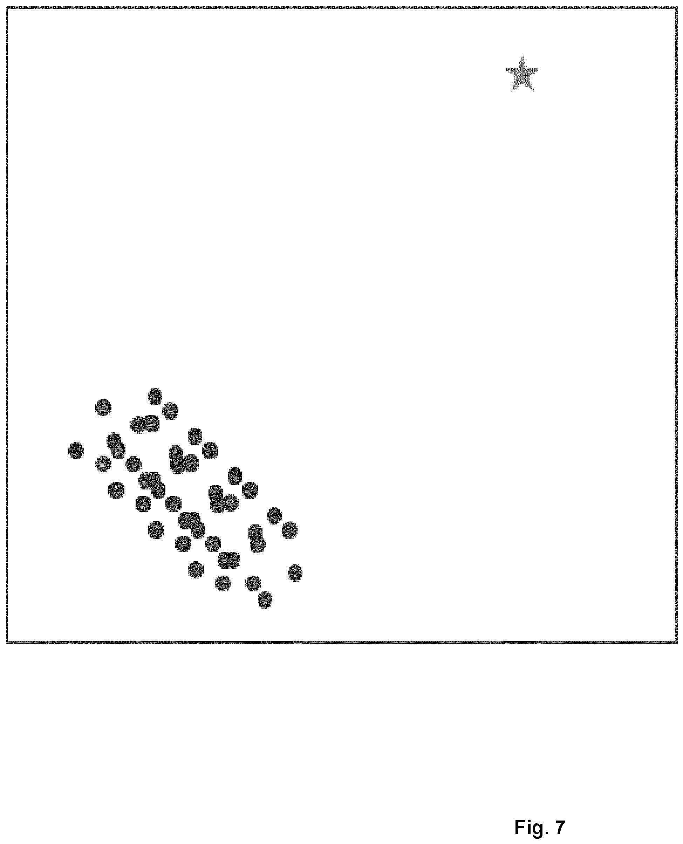

Figure 7 shows a schematic representation of an example 2D representation of the latent space. Normal measurements of statuses or dynamics or environmental conditions of the digital twin respectively the twinned object/asset are grouped within the cluster circled in black and the detected event area one (grey star) is isolated.

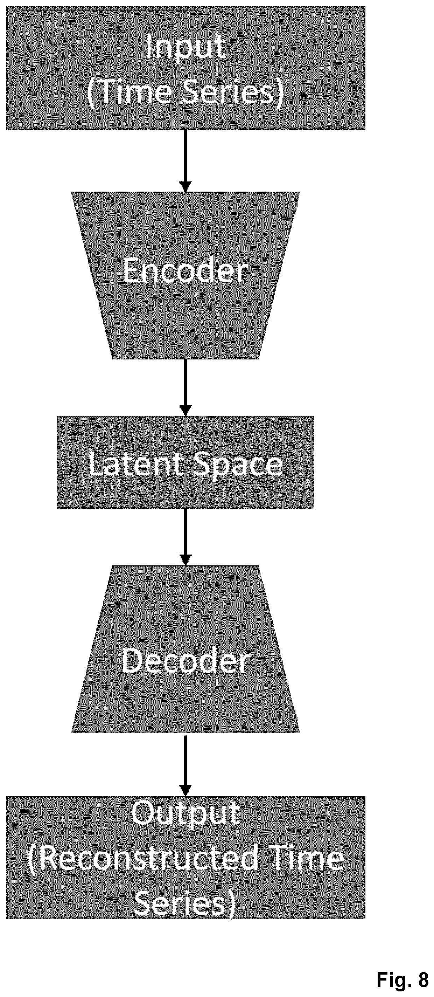

Figure 8 shows a schematic representation of an autoencoder architecture. The network is trained in an unsupervised manner (unsupervised learning) so that the input signal can first be converted to low-dimensional latent space and reconstructed by the decoder with minimal loss of information.

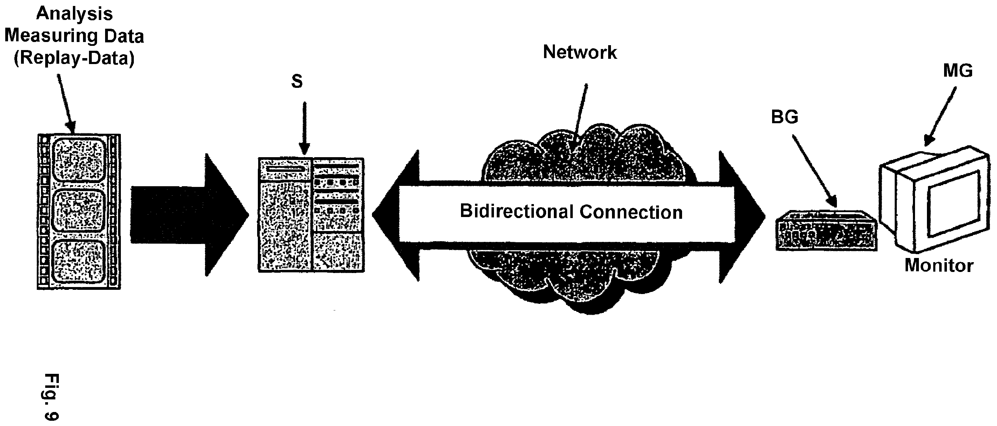

Figure 9 shows a block diagram which schematically illustrates an exemplary replay execution variant with provision of analysis measurement data (as replay data) for monitoring a time section in the replay mode of the digital twin respectively the twinned object/asset. The analysis measurement data are recorded e.g. on a storage medium of a server (S). By means of an assembly (BG) comprising a client for time-shifted retrieval of analysis measurement data, a time section of the replay data shifted in time to real time is selected, e.g., by means of a time tag, and requested, e.g., by means of a request from server S. The latter compiles the requested time section of the replay data stream, e.g., in the form of multimedia data packets, and transmits them over the network to the client of the assembly. The client unpacks the multimedia data packets and displays them on the monitor M for the user.

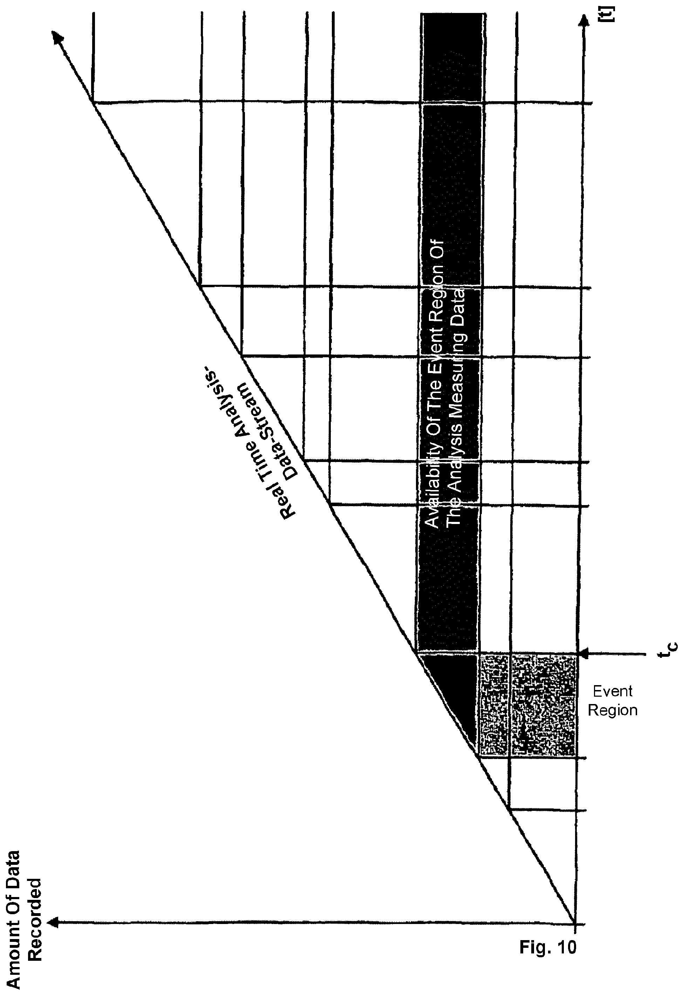

Figure 10 shows a block diagram schematically illustrating an exemplary time-dataset diagram highlighting a time range available for retrieval e.g. including an event detected by the system 1. The entire real time analysis data stream may be recorded or only time ranges of the analysis data stream, i.e. the replay data, in which first and/or second event were detected by the system 1.

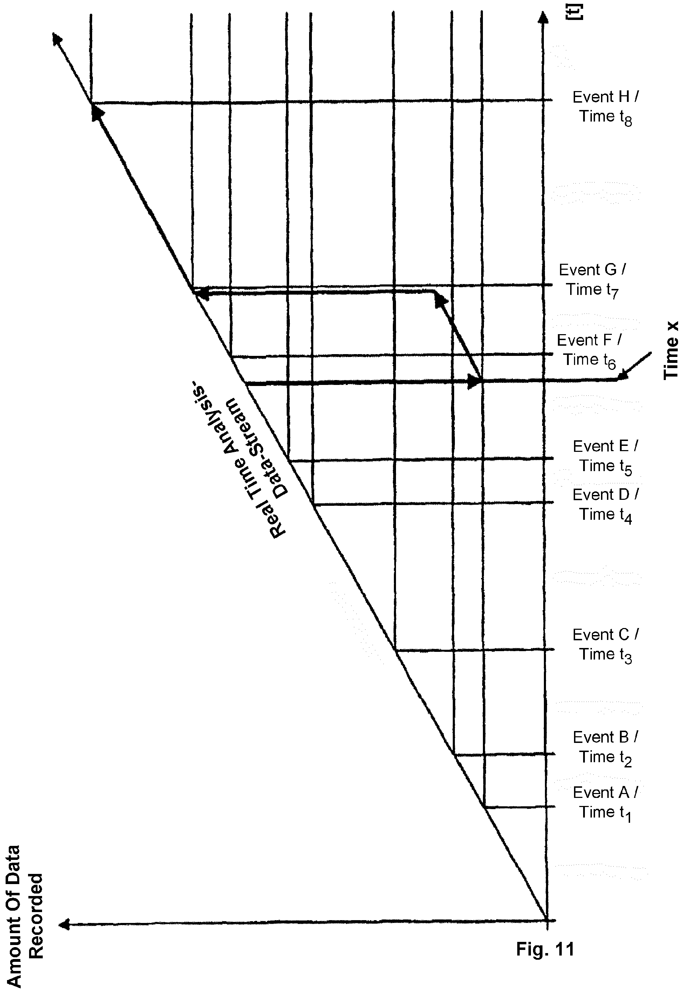

Figure 11 shows a block diagram schematically illustrating an exemplary time-dataset diagram with the highlighting of a rendition of a detected event region lying in the past. As shown in Figure 11, the embodiment according to the invention can also be implemented in such a way that the user can jump to any point in time in the past of the recorded analysis data stream, i.e. independently of event detections. Also the user can e.g. beyond a certain time range time-delayed recall the analysis measurement data from the stored replay data stream, jump at a time x one time range forward (forward) or backward (rewind) in the recorded data stream.

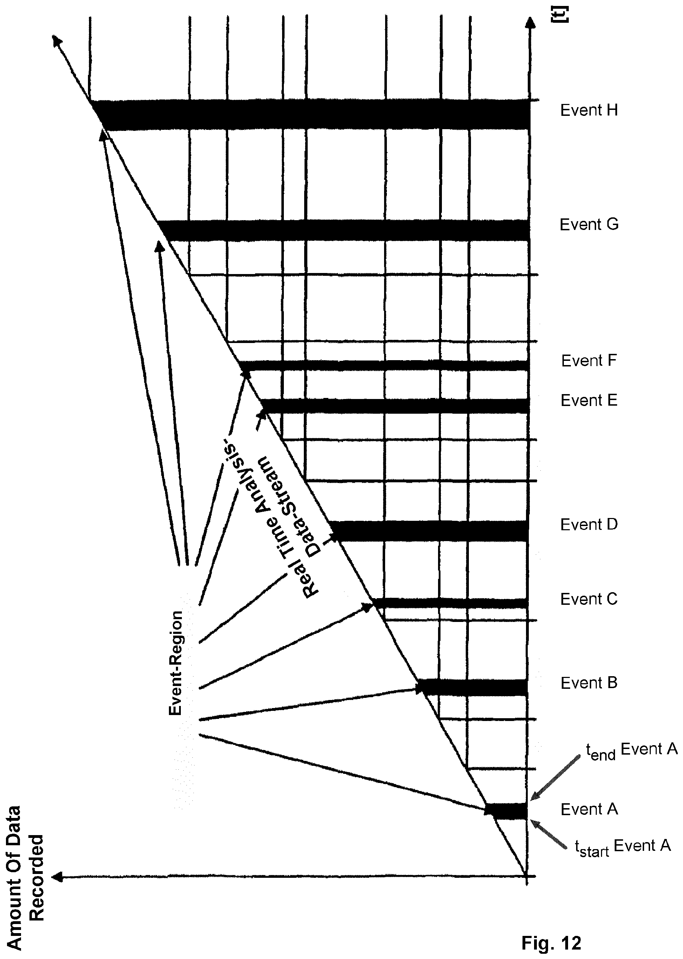

Figure 12 shows a block diagram schematically illustrating an exemplary time-data set diagram, in which embodiment the detected event time ranges are displayed to the user, e.g. via the client on the assembly, for selection. In particular, a further embodiment can be implemented such that the connected digital twin, i.e. the avatar of the twinned object/asset, can be set again by the electronic system controller exactly into the operating mode with the same operating parameters as in the detected event area. The digital twin can thus be run through the anomaly or significant event area again in real time, e.g. for testing, optimization or other verification purposes of the real world object/asset.

### Detailed Description of the Preferred Embodiments

Figures 1-4 schematically illustrate an architecture for a possible implementation of an embodiment of the inventive digital platform 1 for avatar measurements of temporally evolving risk-based real-world measuring parameters. The digital platform 1, at least partially realized as an automated, autonomous operating, electronic, digital cyber-physical production system, comprises at least one data-capturing device or measuring sensor 2 associated with a specific physical or intangible real-world asset 3,31/32 or living object 3,33 to be monitored. The data-capturing devices and/or measuring sensors 2, in particular, can comprise loT sensory and digital sensory networks with appropriate controls, sensors and other devices that make up the digital sensory network. Such sensory network allow seamlessly collecting and communicating data to enable the inventive digital platform 1. Thus, the physical real-world asset 31/32 or living object 33 that is to be twinned is fitted with sensors that measures the desired parameters and forwards them to the connected digital platform 1. Sensory and tracking technology may create real-time streams of measuring data with a predictive potential. The appropriate wearables, trackers, smart home devices and other sensors can so create a constant stream of evolving data that allow to track the evolution of the twinned asset or object 3. Granular streams of data from the used sensory and tracking technology can e.g. be molded into a single digital twin representation 4 by using analytical capabilities of artificial intelligence and machine learning.

The digital twin representation 4 and the digital platform 1, respectively, is based on three technical core characteristics, namely (i) synchronization means for synchronization with the real world asset or object 3, (ii) active data measuring and acquisition from the real environment and/or the real world asset or object 3 and forecast and simulation means giving or forecasting the internal and/or external development of the measuring parameters associated with the twinned system 3 and/or providing the status and/or emerging risk measures associated with the twinned system 3. In addition and at least as an embodiment variant, the digital twin is realized as an intelligent digital twin, wherein the digital platform 1 and/or the digital twin representation include the characteristics of artificial intelligence or other machine learning structures. To realize the proposed architecture for the digital platform 1, several techniques, e.g. Anchor-Point method, methods for heterogeneous data acquisition and data integration or agent-based method for the development of a co-simulation between different digital twin representation, especially for the digital risk twin part, can be implemented. As mentioned above, the digital platform is realized at least partially, as a cyber-physical system, i.e. as an integration of sensor and measuring technology, digital data and cyber methods with physical processes. Embedded computers and networks monitor and control the physical processes, usually with feedback loops, where physical processes affect computations and vice versa.

According to the present invention, the digital twin 4 is a victual representation of a physical asset of object 3 in the digital platform 1, i.e. in the cyber-physical production system, enabled of mirroring its static and dynamic characteristics within certain environmental conditions, i.e. condition parameter settings. The digital platform contains and maps various digital modules to each physical assets or objects 3, of which some are executable, as e.g. simulation or forecast modules. However, not all module are executable, which technically, inter alia, means that the digital twin representation according the present invention is more than just a simulation of a physical asset or object 3. According to the invention, an asset or object 3 can be an entity that already exists in the real world or can be a representation of a future entity that will be constructed or still have to be born. It is important to understand, that the digital twin representation 4 of the present invention can be realized a composite of many individual digital twin representations 4. These digital twin representations 4 communicate with each other by means of the digital platform 1 and are enabled exchange data and information. A digital twin representation 4 of the digital platform 1 can simulate and test various scenarios for reconfiguration of the digital platform 1, such as reliability, energy consumption, process consistency, ergonomics, logistics, virtual commissioning, etc. The different simulation modules interacting with each other, form a co-simulation of the entire system and show the characteristics of the digital platform 1 e. g., the behavior, function, etc. By reconfiguration is meant a modification of parts of an already existing and operating digital platform 1 to meet new requirements, typically arising or emerging from the stream of sensory data measured in the real-world of the physical twin 3 in order to achieve convergence in the parallel development. It is important to understand, that the digital platform 1 as a cyber-physical production system is neither a purely physical object nor a purely virtual object, since its virtual digital core, i.e. the digital twin structure 4 only exist in its dependency to the real-world, physical object 3 and its constant link and sensory data streaming connection to the real-world physical object 3, connecting the digital twin 4 to the twinned real-world object 3 like an unborn child to its mother through the live-spending umbilical cord.

The digital platform 1 comprises a data store 10 with stored modular digital assets/objects elements 101,...,105 each representing a plurality of subsystems 41 of the real-world asset or object 3 for the assembly of a digital twin representation 4 of the physical or intangible real-world assets or living objects 3. The data store 10 can be realized as an electronic repository for persistently storing and managing collections of data which include not just repositories like databases, but also simpler store types such as simple files, etc. The data store can accommodate data in any known formats and data structures and in various formats and data structures at the same time. Thus, the data store is more than a library, since it can technically represent a "data lake" or a "data ocean". Under databases, it is understood herein a series of bytes that is managed by a database management system (DBMS), while a file is understood as a series of bytes that is managed by a file system. Thus, any database or file is a series of bytes that, once stored, can constitute a data store 10, as referred herein. As such, the data store 10 technically provides the basis to hold and abstract and collections of constructive data inside the respective digital platform 1 to build up the digital twin representation 4. The data store 10 can also comprise data lake repositories or data ocean repositories of data holding data in its natural/raw format, e.g. object BLOBs (Binary Large OBject) or files, where a BLOB is understood herein as a collection of binary data stored as a single entity in a database management system. BLOBs can comprise images, audio or other any multimedia objects, or even binary executable code stored as a blob. The modular digital assets or objects elements 101,...,105 are selected and assembled to said digital twin representation 4 from the data store 10 based on captured structural 421, operational 422 and/or environmental 423 property parameters 42 by means of the digital platform 1.

The invention provides the technical structure for making assessments and/or predictions regarding the operation or status of a real world physical system 3, such as industrial plants, e.g. comprising electro-mechanical system, or living objects 3, e.g. human being with health condition. The predicted measures may, inter alia, be based on aging process modelling. For example, it may be helpful to predict the remaining life of a technical system, such as an aircraft engine or a mill plant, to help plan when the system should be replaced or when a certain risk measure for a possible loss exceeds a certain threshold value. An expected life-time or risk measure of a system may be estimated by a prediction or forecast process involving the probabilities of failure of the system's individual components, the individual components having their own reliability measures and distributions, or the probability of an impact of an occurring risk event.

Digital models and modelling executables contain a digital representation of dynamic processes affecting the asset or object or elements of the asset/object, thereby providing its development to future time-frames. It can be distinguished between digital knowledge models (representing the current understanding about relationship of things in the real world. They are often described as digital knowledge graphs, digital risk models (hazard models, rating models, pricing and price development models, etc.) and machine learning model modules that can help to detect non-linear patterns in data to extrapolate the ability to predict outcomes. Having involved a plurality of measuring devices and sensors, the present system is able to constantly or periodically monitor and trigger multiple components of a system, real-world asset or living object 3, each having its own micro-characteristics and not just average measures of a plurality of components, e.g. associated with a production run or slot. Moreover, it may be possible to very accurately monitor and continually assess the health of individual technical components of the physical real-world asset 31/32 or parts of the body of the living object 33, predict their error-proneness, vulnerability, health-status or remaining live-time, and consequently assess and forecast health measures, health risk measures and remaining life-time. Thus, the system provides a significant advance for example for applied prognostics and risk measuring. It further provides the technical basis for discovering and monitor real-world assets and objects 3 in an accurate and efficient manner allowing, inter alia, to precisely trigger risk measures, or in the context of production systems to reduce unplanned, losses, break downs or at least the associated down time for complex systems. The inventive system 1 also allows to achieve a nearly optimal control of a twined physical system if the relevant sensory data can by measures and assessed, if the life of the parts and degradation of the key components can be accurately determined or, in case of living objects 33, if the health status and condition of the relevant organs can be correctly measured. According to the present invention, these forecast measures are provided by a digital twin 4, in particular a digital risk twin, of a twinned physical system 3.

By means of the at least one input device or sensor 2 associated with the twinned physical asset or object 3, structural 431, operational 432 and/or environmental 433 status parameters 43 of the real-world asset or object 3 are measured and transmitted to the digital platform 1. The status parameters 43 are assigned to the digital twin representation 4, wherein the values of the status parameters 43 associated with the digital twin representation 4 are dynamically monitored and adapted based on the transmitted parameters 43, and wherein the digital twin representation 4 comprises data structures 44 representing states 441 of each of the plurality of subsystems 41 of the real-world asset or object 3 holding the parameter values as a time series of a time period.

Some embodiments are directed to an Internet of Things associate to facilitate implementation of a digital twin of a twinned physical system. For these variants, the loT associate may include a communication port to communicate with at least one component, the at least one component comprising a sensor 2 or an actuator associated with the twinned physical system 3, and a gateway to exchange information via the loT. The digital platform 1 and local data storage, coupled to the communication port and gateway, may receive the digital twin 4 from the data store via the loT. The digital platform 1 may be programmed to, for at least a selected portion or subsystem 34 of the twinned physical system 3, execute the digital twin 4 in connection with the at least one component and operation of the twinned physical system 3.

The structural and/or operational and/or environmental status parameters 43 can e.g. comprise endogen parameters, whose values are determined by the real-world asset or object, and/or exogen parameters, whose values origin from and are determined outside the real-world asset or object and are imposed on the real-world asset or object. The digital platform 1 can e.g. comprise associated exteroceptive sensors or measuring devices for sensing exogen environmental parameters physically impacting the real-world asset or object and proprioceptive sensors or measuring devices for sensing endogen operating or status parameters of the real-world asset or object. The sensors or measuring devices can e.g. comprise interfaces for setting one or more wireless or wired connections between the digital platform 1 and the sensors or measuring devices 2, wherein data links are settable by means of the wireless or wired connections between the digital platform 1 and the sensors or measuring devices 2associated with the real-world asset or object 3 transmitting the exogen and endogen parameters measured and/or captured by the sensors or measuring devices 2 to the digital platform 1.

By means of the digital platform 1, data structures 44 for the digital twin representation 4 representing future states 441 of each of the plurality of subsystems 41 of the real-world asset or object 3 are generated as value time series over a future time period based on an application of simulations using cumulative damage modelling processing, the cumulative damage modelling generating the effect of the operational and/or environmental asset or object parameters on the twinned real-world asset or object 3 of the future time period. Modelling and appropriate parameter value processing, as understood herein, technically contain a digitized, formalized representation of the known time-related influences and damage mechanisms.
Concerning the digital engineering, the cumulative damage modelling can comprise digital knowledge modelling for the knowledge engineering, time-dependent risk modelling and machine learning modelling that are able to detect non-linear patterns in data to extrapolate the ability to predict outcomes, where the digital knowledge models represent and capture the relationship of the objects in the real world, e.g. described as knowledge graphs. Knowledge graphs are structured knowledge in a graphical representation, which can be used for a variety of information processing and management tasks such as: (i) enhanced (semantic) processing such as search, browsing, personalization, recommendation, advertisement, and summarization, 2) improving integration of data, including data of diverse modalities and from diverse sources, 3) empowering ML and NLP techniques, and 4) improve automation and support intelligent human-like behavior and activities that may involve robots. For example, for a micromechanical device, a micromechanics modelling can be used that includes the internal and external effects on the device can be used in a cumulative damage scheme to predict the time-dependent fatigue behavior. Parameters can be used to model the degradation of the device under fatigue loading. A rate equation that describes the changes in efficiency as a function of time cycles can be provided using experimentally determined reduction data. The influence of efficiency parameters on the strength can be assessed using a micromechanics model. The effect of damage probability measures on the device can be provided by solving a boundary value problem associated with the particular damage mode (e.g. transverse matrix cracking). Predictions from such technical modelling can be backchecked and compared with experimental data, e.g. if the predicted fatigue life and failure modes of the device agree very well with the experimental data. The modelling of the present invention (especially machine learning and risk modelling, i.e. modelling of probability measures of future occurring events) leverage time-series data in order to build a view from the past that can be projected towards the future.

All mentioned prediction and modelling modules (especially risk-based and/or machine learning) leverage timeseries data in order to build a view from the past that can be projected towards the future. This also applies to establish frequency and severity measures of events that can be used for risk-based purposes. A risk measure or risk-exposure measure is understood herein as the physically measurable probability measure for the occurrence of a predefined event or development. As mentioned, historical measuring data are also fundamentals to establish frequency and severity of events that can be used for risk measures. Historical data can be used in all areas, like general dimensions (e.g. measuring weather, GDPs (Gross Domestic Products), risk events) as well as more risk-transfer related (e.g. measuring economic losses, insured losses). In the above example of the micromechanical device, the historical data can, inter alia, be also be weighted by experimental step-stress test data to verify the cumulative exposure/damage modelling structure.

By means of the digital platform 1, the digital twin representation 4 is analyzed providing a measure for a future state or operation of the twinned real-world asset or object 3 based on the generated value time series of values over said future time period, the measure being related to the probability of the occurrence of a predefined event to the real-world asset or object 3. The digital twin 4 of twinned physical system 3 can, according to some embodiments, access the data store, and utilize a probabilistic structure creation unit to automatically create a predictive structure that may be used by digital twin modeling processing to create the predictive risk/occurrence probability measure.

To process the generated effects captured and measured by physical measuring parameters to the operational and/or environmental asset parameters on the twinned real-world asset 3 of the future time period, the cumulative damage modelling by machine learning modules further can comprise the step of detecting first anormal or significant effects within a generated and measured time series of parameters, wherein the detection of anomaly and significant events is triggered by exceeding the measured deviation from a defined threshold value per a single or set of operational and/or environmental asset parameters.

The system detects second anomaly and significant events based on the time series of the defining the status of operation of the digital twin. By means of dynamic time normalization the topological distance between the measured time series of the parameters over a time is determined as a distance matrix. The dynamic time normalization can be realized e.g. based on Dynamic Time Wrapping. A measured time series signal of the event rates can be matched e.g. as spectral or cepstral value tuples with other value tuples of measured time series signal of the event rates. The value tuples can be supplemented, for example, with further measurement parameters such as one or more of the present digital twin parameters and/or environmental parameters discussed above. Using a weighting for the individual parameters of each measured value tuple, a difference measure between any two values of the two signals is established, for example a normalized Euclidean distance or the Mahalanobis distance. The system searches for the most favorable path from the beginning to the end of both signals via the spanned distance matrix of the pairwise distances of all points of both signals. This can be done e.g. dynamic efficient. The actual path, i.e. the wrapping, is generated by backtracking after the first pass of the dynamic time normalization. For the pure determination, i.e. the corresponding template selection, the simple pass without backtracking is sufficient. The backtracking, however, allows an exact mapping of each point of one signal to one or more points of the respective other signal and thus represents the approximate time distortion. It should be added that in the present case, due to algorithmic causes in the extraction of the signal parameters of the value tuples, the optimal path through the signal difference matrix may not necessarily correspond to the actual time distortion.

By means of a statistical data mining unit of the system, the measured and dynamically time-normalized time series are then clustered into disjoint clusters based on the measured distance matrix (cluster analysis), whereby measured time series of a first cluster index a virtual twin operation or status in a norm range and measured time series of a second cluster index a virtual twin operation or status outside the norm range. Clustering, i.e. cluster analyses, can thus be used to assign similarity structures in the measured time series, whereby the groups of similar measured time series found in this way are referred to here as clusters and the group assignment as clustering. The clustering by means of the system is done here by means of data mining, where new cluster areas can also be found by using data mining. The automation of the statistical data mining unit for the clustering of the distance matrix can be realized e.g. based on density based spatial cluster analysis processing with noise, in particular the density based spatial cluster analysis with noise can be realized based on DBScan. DBScan as spatial cluster analysis with noise works density based and is able to detect multiple clusters. Noise points are ignored and returned separately.

As a pre-processing step, e.g. pre-processing, a dimensionality reduction of the time series can be performed. In general, the analysis data described above are composed of a large number of different time series, e.g. with a sampling rate of up to 500 ms or more, if required by the dynamics of the twinned system/asset/living object. Here, each variable can be divided into two types of time series, for example: (1) Timesliced time series, when the time series can be naturally divided into smaller pieces when a process or dynamic of a twinned system is over (e.g., operational cycles, day time cycles etc.); and (2) Continuous time series: When the time series cannot be split in an obvious way and processing must be done on it (e.g., sliding window, arbitrary splitting, ...). In addition, time series can also be univariate or multivariate: (1) Univariate time series: the observed process is composed of only one measurable series of observations (e.g. structural parameters of the twinned object); (2) Multivariate time series: The observed process is composed of two or more measurable series of observations that could be correlated (e.g., structural parameters and condition/state of the twinned object or an element of the twinned object).

The use of time series for processing steps of the system presents a technical challenge, especially if the time series are of different lengths (e.g., operational parameter/environmental measuring parameter time series). In the context of the inventive system, it may therefore be technically advantageous to preprocess these time series into a more directly usable technical format using preprocessing. Using the dimensionality reduction method, a latent space can be derived from a set of time series. This latent space can be realized as a multidimensional space containing features that encode meaningful or technically relevant properties of a high-dimensional data set. Technical applications of this concept can be found in natural language processing (NLP) methods with the creation of a word embedding space derived from text data or, in the present case, a time series embedding space, or in image processing, where a convolutional neural network encodes higher-order features of images (edges, colors ...) in its final layers. According to the invention, this can be technically realized by creating a latent space of several time series from replay data and using this latent space as a basis for subsequent tasks such as event detection (see Figure 7), classification or regression tasks. In the present case, a latent space can be generated for time series signals with technical approaches such as principal component analysis and dynamic time wrapping, and also with deep learning-based technical approaches similar to those used for computer vision and NLP tasks, such as autoencoders (see Figure 8) and recurrent neural networks.

Regarding the generation of the time series embedding space, the fundamental technical problem that complicates the technical modeling and other learning problems in the present case is dimensionality. A time series or sequence on which the model structure is to be tested is likely to be different from any time series sequence seen during training. Technically, possible approaches may be based, for example, on n-grams that obtain generalization by concatenating very short overlapping sequences seen in the training set. In the present case, however, the dimensionality problem is combated by learning a distributed representation for words that allows each training set to inform the model about an exponential number of semantically adjacent sentences. The modelling simultaneously learns (1) a distributed representation for each time series along with (2) the likelihood function for time series sequences expressed in terms of these representations. Generalization is achieved by giving a sequence of time series that has never been recognized before a high probability if it consists of time series that are similar (in the sense of a close representation) to time series that form a set that has already been seen. Training such large models (with millions of parameters) within a reasonable time can itself be a technical challenge. As a solution for the present case, neural networks are used, which can be used e.g. for the likelihood function. On two time series sets it could be shown that the approach used here provides significantly better results compared to state-of-the-art n-gram models, and that the proposed approach allows to use longer time series and time series contexts.

In the present case, the ability of multilayer backpropagation networks to learn complex, high-dimensional, nonlinear mappings from large collections of examples makes these neural networks, particularly Convolutional Neural Networks, technical candidates for the time series recognition tasks. However, there are technical problems for application in the present invention: In the technical structures for pattern recognition, typically a manually designed feature extractor collects relevant information from the input and eliminates irrelevant variability. A trainable classifier then categorizes the resulting feature vectors (or strings) into classes. In this scheme, standard, fully connected multilayer networks can be used as classifiers. A potentially more interesting scheme is to eliminate the feature extractor, feed the mesh with "raw" inputs (e.g., normalized images), and rely on backpropagation to turn the first few layers into a suitable feature extractor. While this can be done with an ordinary fully connected feed-forward network with some success for the task of detecting the time series, there are technical issues in the present context. First, time series of measurement parameters can be very large. A fully-linked first layer, e.g., with a few hundred hidden units, would therefore already require several 10'000 weights. An overfitting problem occurs if not enough training data is available. Also the technical requirements for the storage medium grow enormously with such numbers. However, the technical skin problem is that these networks have no inherent invariance with respect to local biases in the input time series. That is, the pre-processing discussed above with the appropriate normalization or other time normalization must normalize and center the time series. Technically, on the other hand, no such pre-processing is perfect.

Second, a technical problem of fully-linked networks is that the topology of the input time series is completely ignored. The input time series can be applied to the network in any order without affecting the training. However, in the present case, the processing process has a strong local 2D structure, and the time series of measurement parameters have a strong 1D structure, i.e., measurement parameters which are temporally adjacent are highly correlated. Local correlations are the reason that extracting and combining local features of the time series before recognizing the spatial or temporal objects is proposed in the context of the invention. Convolutional neural networks thereby enforce the extraction of local features by restricting the receptive field of hidden units to local units. In the present case, the use of Convolutional Networks technically ensures in the recognition of the time series that displacement and depletion invariance is achieved, namely through the application of local receptive fields, joint weights (or weight replications), and temporal subsampling of the time series. The input layer of the networks thereby receives time series that are approximately time-normalized and centered (see Time Wrapping above).

For generating the latent space for the time series signals, as described above, e.g. principal component analysis and dynamic time wrapping or deep learning based technical approaches can be chosen, such as the use of recurrent neural networks. However, in the present invention, it should be noted that learning information over longer time intervals using recurrent backpropagation can take a very long time, usually due to insufficient decaying error feedback. Therefore, in the context of the invention, the use of a new, efficient and gradient-based method. Here, the gradient is truncated where it does no harm so that the network can learn to bridge minimal time delays of more than 1000 discrete time steps by enforcing a constant error flow through constant rotations of the errors within a specific unit. Multiplicative gate units thereby learn to open and close access to the constant error flow. By this embodiment according to the invention, the network remains local in space and time with respect to learning the time series.

With respect to the autoencoder embodiment (see Figure 8), the network is trained in an unsupervised manner (unsupervised learning) so that the input signal can first be converted to low-dimensional latent space and reconstructed by the decoder with minimal information loss. The method can be used to convert high-dimensional time series into low-dimensional ones by training a multi-layer neural network with a small central layer to reconstruct the high-dimensional input vectors. Gradient descent can be used to fine-tune the weights in such "autoencoder" networks. However, this only works well if the initial weights are close to a suitable solution. In learning the time series, the embodiment described here provides an effective way of initializing the weights that allows the autoencoder network to learn low-dimensional codes that perform better than principal component analysis as a tool for reducing the dimensionality of data. Dimensionality reduction of time series according to the invention facilitates classification, visualization, communication, and storage of high-dimensional time series. One possible method is principal component analysis (PCA), which finds the directions of greatest variance in the time series and represents each data point by its coordinates along each of these directions. For example, as an embodiment variant, a nonlinear generalization of PCA can be used by using an adaptive multilayer "encoder" network to transform high-dimensional time series into low-dimensional codes, and a similar decoder network to recover the time series from the codes. In the embodiment, starting from random weights in the two networks, they can be trained together by minimizing the discrepancy between the original time series and their reconstruction. The system obtains the required gradients by applying a chain rule to propagate the error derivatives back first through the decoder network and then through the encoder network. This system is referred to here as an autoencoder.

The above-discussed unsupervised machine learning procedure for dynamic time-wrapping based (DTW) time series detection, can also be done supervised. Two execution variants of learning strategies, supervised and unsupervised, can be applied with the DTW for the time series according to the invention. For example, two supervised learning methods, incremental learning and learning with priority denial, can be distinguished as execution variants. The incremental learning procedure is conceptually simple, but typically requires a large set of time series for matching. The learning procedure with priority denial can effectively reduce the matching time, while typically slightly decreasing the recognition accuracy. For the execution variant of unsupervised learning, in addition to the variant discussed above, an automatic learning approach based on most-matching learning and based on learning with priority and rejection can also be used, for example. The most-matching learning revealed here can be used to intelligently select the appropriate time series for system learning. The effectiveness and efficiency of all three machine learning approaches for DTW just proposed can be demonstrated using appropriate time series detection test.

In case of detecting first and/or second anomaly and significant events associated with a digital twin respectively with the twinned object/asset, the measured event dynamics or statuses are transmitted as a function of time as input data patterns to a machine-learning unit and the measuring parameters of the digital twin are adjusted by means of the electronic system control based on the output values of the machine-learning unit, wherein the machine-learning unit classifies the input patterns on the basis of learned patterns and generates corresponding metering parameters. By additionally measuring structural/operational parameters comprising measurement parameters for detecting physical properties of the twinned asset/object by means of measuring devices, and/or asset/object parameters by means of proprioceptive sensors or measuring devices, and/or environmental parameters by means of exteroceptive sensors or measuring devices at least comprising air humidity and/or air pressure and/or ambient temperature and/or local temperature distributions, e.g., the machine-learning unit can be adapted to the input patterns on the basis of the measured time series data. e.g., in addition to the measured time series of dynamics/statuses, one or more of the asset/object operational parameters and/or the structural parameters and/or the environmental parameters can be transmitted as a function of time to the machine-learning unit as an input data pattern. The machine-learning unit may be implemented, for example, based on static or adaptive fuzzy logic systems and/or supervised or unsupervised neural networks and/or fuzzy neural networks and/or genetic algorithm-based systems. The machine-learning unit may comprise, for example, Naive Bayes classifiers as a machine-learning structure. The machine-learning unit may be implemented, for example, based on supervised learning structures comprising Logistic Regression and/or Decision Trees and/or Support Vector Machine(SVM) and/or Linear Regression as machine-learning structure. For example, the machine-learning unit may be realized based on unsupervised learning structures comprising K-means clustering or K-nearest neighbor and/or dimensionality reduction and/or association rule learning. The machine-learning unit may be realized, for example, based on reinforcement learning structures comprising Q-learning. For example, the machine-learning unit may be implemented based on ensemble learning comprising bagging (bootstrap aggregating) and/or boosting and/or random forest and/or stacking. Finally, the machine-learning unit can be realized based on neural network structures comprising feedforward networks and/or Hopfield networks and/or convolutional neural networks or deep convolutional neural networks.

As used herein, the term "automatically" may refer to, for example, actions that can be performed with little or no human intervention. As further used herein, devices, including those associated with the digital platform 1 may exchange information via any communication network which may be one or more of a Local Area Network ("LAN"), a Metropolitan Area Network ("MAN"), a Wide Area Network ("WAN"), a proprietary network, a Public Switched Telephone Network ("PSTN"), a Wireless Application Protocol ("WAP") network, a Bluetooth network a wireless LAN network, and/or an Internet Protocol ("IP") network such as the Internet, an intranet, or an extranet. Note that any devices described herein may communicate via one or more such communication networks. The digital risk twin 4 of the twinned physical system 3 can e.g. store information into and/or retrieve information from various data sources, such as the sensors 2, the data store etc.. The various data sources may be locally stored or reside remote from the digital twin 4 of the twinned physical system 3.

By means of the digital platform 1, the control of an operation or status of the real world asset or object 3 can be optimized or adjusted to predefined operational and/or status asset or object parameters of the specific real-world asset or object 3 based on the provided measure for a future state or operation of the twinned real-world asset or object 3 and/or based on the generated value time series of values over said future time period. In case of an optimized control of operation, the optimized control of operation is generated to jointly and severally increase the specific operating performance criteria in time and future of the real-world asset or object or decrease a measure for an occurrence probability associated with the operation or status of the real-world asset or object within a specified probability range. The decrease of the measure for an occurrence probability associated with the operation or status of the real-world asset or object 3 can e.g. be based on a transfer of risk to an automated risk-transfer system controlled by the digital platform, wherein values of parameters characterizing the transfer of risk are optimized based on said measure for a future state or operation of the twinned real-world asset or object 3 and/or based on the generated value time series of values over said future time period. In order to optimize the status of the real-world asset or object 3 or the probability of an occurrence of a predefined risk event, an optimizing adjustment of at least a subsystem 34 of the real-world asset of object 3 can e.g. be triggered by means of the digital platform 1. The triggering by means of the digital platform 1 can e.g. be performed by electronic signal transfer.

As variant, the digital twin 4 of the twinned physical system 3, i.e. the digital virtual replicas are constantly updated and analyzed by measuring data from their real counterparts, i.e. the twinned physical system or object 3 and from the physical environment that surrounds them in their real physical world. The digital platform 1 is able to react on the digital twin 4 and it can run analysis related to historical data, current data and forecasts. It is able to predict what will happen in each case and the associated risk, and thus be able automatically propose actions and provide appropriate signaling. Even the virtual twin itself or the digital platform 1, respectively, can act, when technically realized as such, on the technical means of its real-world twin 3, given that the two are linked by appropriate technical means. For example, by electronically sensing and triggering the occurrence of one or more specified threshold values emerging from or otherwise popping up at the digital twin 4 by means of a trigger or control module of the digital platform 1, electronic signaling can be generated by means of a signaling module and a data-transmission interface of digital platform 1, which is transmitted over a data-transmission network to the corresponding technical means or a PLC (Programmable Logic Controller) steering the corresponding technical means of the digital twin 4. In this case, the digital platform 1 is connected via the data-transmission network, which can include a land-based and/or air-based wired or wireless network; e.g., the Internet, a GSM network (Global System for Mobile Communication), an UMTS network (Universal Mobile Telecommunications System) and/or a WLAN (Wireless Local Region Network), and/or dedicated point-to-point communication lines. As the measuring sensors at the real-world asset or object 3, the corresponding technical means can be connected to the digital platform by telematics devices, allowing a continuous monitoring and control of the real-world twin 3. The corresponding technical means of the real-world twin 3 can e.g. comprise switches (e.g. on/off switches) activating or deactivating the associated technical means or the operation of the real-world asset or object 3 to prevent damage or loss at the real-world asset or object 3. In case of a living real-world object 3, the corresponding technical means can e.g. comprise electronic alarm means signaling an imminent occurrence of a damage or loss event to the living object 3 or emergency systems, as e.g. a heart attack or stroke. The PLCs, as mentioned above, are enabled to electronically control and steer appropriate technical means of the real-world asset or object 3, and can range from small modular devices with tens of inputs and outputs (I/O), in a housing integral with the processor, to large rack-mounted modular devices with a count of thousands of I/O, and which are often networked to other PLC and SCADA (Supervisory Control And Data Acquisition) systems. The PLCs can be designed for multiple arrangements of digital and analog I/O, extended temperature ranges, immunity to electrical noise, and resistance to vibration and impact. Executable program codes to control a possible machine operation at the real-world asset 3 can e.g. be stored in battery-backed-up or non-volatile memory.

The present invention has inter alia the advantage, that the digital platform 1 is consolidated in Industry 4.0 technology, especially providing new technical advantages in the automation of risk-transfer and insurance technology, in particular automated risk control and management systems. For example in the case of automated means for risk-transfer in the context of associated vehicles or houses, their nowadays increasing hyper-connection will contribute to the construction of the digital twins 4 by means the digital platform 1, so that the platform 1 provides new technical ways to generate predictive modelling and offer automated personalized services. Especially, if the subject of the risk-transfer is not a real-world asset 3 but a living object 3, that brings a degree of complexity, where trying to forecast and predict human factors will always involve a considerable margin of error, and the inventive digital platform 1 is able to solve by means of the digital risk twins challenge in the risk-transfer technology, where prior art systems are not able to cope with. As an increasing amount of personal data are generated e.g. through smartphones, fit-bits or other devices e.g. in smart homes, for example, prior art systems are, despite the availability of more and more data, not able to make them coherent and to translate them into probable behavior (and its associated risk measures). Thus, the inventive system 1 is able to play a key role that allows a more direct and personalized relationship with the living object 3 (i.e. the risk-transfer client) and is able to provide a critical technical role as new intermediary between data providers and risk-transfer systems, specialized in interpreting the accumulating big data of risk-transfer customers by linking it to the generation of appropriate digital twins 4.

As an embodiment variant, based on the measure for a future state or operation of the twinned real-world asset or object, a forecasted measure of an occurrence probability of one or more predefined risk events impacting the real-world asset or object 3 can e.g. be generated by propagating the parameters of the digital twin representation 4 in controlled time series. As a further embodiment variant, the digital platform can e.g. comprise and trigger an automated expert system of the digital platform 1 by means of electronic signal transfer, wherein the digital platform 1 triggers the transmission of a digital recommendation to a user interface generated by the expert system of the digital platform based on the measured value of the measure for a future state or operation of the twinned real-world asset or object and/or the measured probability of the occurrence of a predefined physical event to the real-world asset or object 3, The digital recommendation comprises indications for an optimization of the real-world asset or object 3 or adaption of the structural, operational and/or environmental status parameters.

Figures 3 and 4 show a more detailed schematic representation of the digital risk twin 4, in particular the digital asset/object replica 48, the digital twin 47, the digital ecosystem replica 46, the digital risk robot 46 and the digital twin 4 with its optional artificial intelligence 45 of a physical entity 3 in the inventive digital platform 1. In the digital platform 1 and digital risk twin 4, respectively, each physical asset/object 3 consists of its digital modelling structures 481, 482, 483,..., 48i and associated data and . its digital modelling structures 461, 462, 463,..., 46i and associated data. The digital twin 47 with the digital asset/object replica 48 is realized as a continuously updated, digital structure hold by the digital platform 1 that contains a comprehensive physical and functional description of a component or system throughout the life cycle. As such, the digital risk twin 4 provides a realistic equivalent digital representation of a physical asset or object 3, i.e. a technical avatar, which is always in synch with it. It allows to run a simulation on the digital representation to analyze the behavior of the physical asset. Additionally, each digital risk twin 4 of the digital platform 1 can comprise a unique ID to identify a digital risk twin 4, a version management system to keep track of changes made on the digital risk twin 4 during its life cycle, as already describe above, interfaces between the digital risk twins 4 for co-simulation and inter-twin data exchange, interfaces within the digital platform, in which the digital risk twins 4 are executed an/or held, and interface to other digital risk twin for co-simulation. Further aspects of a digital risk twin 4 relate to the internal structure and content, possible APIs and usage, integration, and runtime environment. The aspect of APIs and usage relate to the possible requirements for interfaces of the digital risk twin 4, in particular such as cloud-to-device communication or access authorization to information of the digital risk twin 4. For such integration the system 1 comprises an identification mechanism for unambiguous identification of the real asset/object 3, a mechanisms for identifying new real assets/objects 3, linking them to their digital risk twin 4, and synchronizing the digital risk twin 4 respectively its twinned subsystems with the real asset/object 3, and finally technical means for combining several digital risk twin subsystems into a digital risk twin 4. The ID provides the technical identification of a unique digital risk twin 4 with an real-world asset/object. With the help of this unique ID, the data and modelling structures of the digital risk twin 4 are stored as a module on a database containing all data and information and can be called any time during engineering or reconfiguration. This obviously supports modularity in the context of modular system engineering. A digital risk twin 4 provides the means to encapsulate the subsystems of a real-world asset/object 4. For example, CAD models, electrical schematic models, software models, functional models as well as simulation models etc. Each of these models can e.g. be created by specific means during the engineering process of a digital risk twin 4. An important feature are the interfaces between these means and their models. Tool interfaces can be used to provide interaction between modelling structures. For example, the modelling structures can be updated or reversioned during the entire life cycle or domain-specifically simulated with the aid of different inputs. The digital risk twin 4 of a real-world asset/object 3 should not only contain current modelling structures, but also all generated modelling structures during the entire lifecycle. This, for example, can support efficient engineering during reconfiguration and expandability throughout the lifecycle. Digital risk twin 4 time-series management provides access to all stored versions of the modelling structures and their relations. This allows the old version to be called up any time at the request of an engineer, taking into account the circumstances during engineering or reconfiguration, and to switch to the current version. As describe above, in order to accurately reflect the behavior and current state of the real-world asset/object 3, the digital risk twin 4 must contain current operation data of the asset/object 3. This can be sensor data, which are continuously streamed and recorded, as well as control data, which determines the current status of the real component, also recorded over the entire lifecycle. Finally, as a variant, a co-simulation interface for communication with other digital risk twins 4 can be provided to obtain more precise image of reality. For example, a data exchange can enable multidisciplinary co-simulation in the digital platform 1. This can be used to simulate the process flow of the entire system 1 in the real world.

As discussed above, the digital risk twin 4 can comprise an artificial intelligence layer 41. Such an intelligent digital risk twin 4 rises the system 1 to an complete autonomous level compare to the digital risk robot 45 in the digital platform 1. This allows the digital platform 1 and the digital risk twin 4 to cope with the streaming data amount coming from the measuring devices of the real-world asset/object 3, which can comprise, for example telematic devices of smart homes or smart cities or cars, in particular autonomous car system, in case of a real-world asset 31/32, or in case of a living object, as a human, wearable devices measuring body-related parameters. It is to be noted, that the digital platform 1 may comprise different digital risk twins related to different aspects of a user's life, as e.g. an loT-based smart-home digital risk twin 4, a telematic-based vehicle digital risk twin 4, and/or a telematic-based body risk twin 4, enabling the system 1 to measure and trigger extended and/or combined risk exposure measures of a certain user. In the context of smart-homes, smart-cities, interconnected cars and the like, interoperability can be achieved either by adopting universal standards for a communication protocol or by using a specialized device in the network that acts like an interpreter among the different measuring and sensory devices and protocols. The interoperability in the context of loT-based and/or telematics and/or smart wearable devices and big data solutions can so be achieved.

An intelligent digital risk twin 4, using the entire system's actual digital risk twin 45, can be used to realize processes such as optimization of the process flow, automatic control code generation for newly added real-world devices/assets/objects 3 in the context of plug and produce and predictive maintenance using stored operation data in the digital risk twin 4 throughout the lifecycle. To realize this, additional components are required to equip the digital risk twin 4 architecture with intelligence. As shown in fig. 3, for such additional components, being the digital replica layers 46/48 modelling comprehension, intelligent digital risk twin algorithms 41 and e.g. extra interfaces for communicating with the physical asset/object 3 are added to the architecture of the digital risk twin 4 to make it self-adaptive and intelligent.

To dynamically synchronize the digital risk twin 4 with the physical asset/object throughout the entire lifecycle of the twin 4, the digital platform 1 and the digital risk twin 4, respectively, comprise the technical means to understand and manage all modelling structures and data. Accordingly, the digital risk twin 4 modelling comprehension in the structure of figure 3 fulfills this purpose by storing information of the interdisciplinary modelling structures 46/48 within the digital risk twin 4 and its relations to other digital risk twins 4. The digital risk twin 4 modelling structure is realized with a standardized semantic description of modelling structures, data and processes for a uniform understanding within the digital risk twin 4 and between digital risk twins 4. Technologies to implement such a standardization can, for example, be OPC UA (OPC: Open Platform Communications, UA: Unified Architecture) or OWL (Web Ontology Language of the World Wide Web Consortiums (W3C)).

The autonomous, intelligent digital risk twin 4 comprises two important capabilities regarding the processing of acquired operation data. It applies appropriate algorithms on the data to conduct data analysis. The algorithms extract new knowledge from the data which can be used to refine the modelling structure of the digital risk twin 4 e. g., behavior modelling structures. Thus, the intelligent digital risk twin 4, as embodiment variant, can provide electronic assistance and appropriate signaling e.g. to a worker at a plant to optimize the production in various concerns. Further, an digital risk twin 4 incrementally improves its behavior and features and thus steadily optimize its behavior, as e.g. the mentioned signaling to the worker of the plant. Therefore, dependent on the type of the twinned real-world asset/object 3, the digital risk twin 4 can provide autonomous steering signaling and electronic assistance signaling for different use cases such as process flow, energy consumption, etc.

Concerning co-simulation of different digital risk twins 4, in case of industrial assets 31, an optimized combination and process chain between digital risk twins 4 can e.g. be realized by parameterizing the existing modelling structures in relation to other digital risk twins 4 in a co-simulation environment. Based on the results of this simulative environment, the intelligent digital risk twin 4 triggers a parametrization of physical assets 31. In another example, the time-dependent evolving structure of a digital risk twin 4 is e.g. used to optimize individual parameters of the real-world asset or object 3, i.e. to determine optimal real-world asset's or object's 3 parameters. For example, as a consequence, the amount of degraded products can be minimized leading to an increased quality of a concerned manufacturing process, as e.g. a milling process.

According to another embodiment variant, other artificial intelligence algorithms 41 deal with automated code generation, for example through serviceoriented architecture approaches for real machines based on the new requirements. This allows approaches such as plug and process to be realized. Other intelligent algorithms 45 can e.g. provide a simulation-based diagnostic and prediction processing through data analysis and knowledge acquisition, for example in the context of desired predictive maintenance. Such machine-based intelligence 45 can e.g. comprise algorithms to product failure analysis and prediction, algorithms to optimization and update of process flow, algorithms for generating a new control program for the twinned real-world asset 31 based on new requests, algorithms for energy consumption analysis and forecast etc. As an embodiment example of autonomous analysis of a digital risk twin 4, an example for a production plant as real-world asset 31 is provided in the context of historical process data of such production plants to predict future maintenance intervals or to maximize the availability of the plant (i.e. predictive maintenance signaling). To extract a model from or find correlations within operation data, unsupervised learning techniques such as k-means clustering or auto encoder networks with LSTM cells can be applied on time series data. In case of k-means clustering with sliding windows, the learned time-sensitive cluster structure is used as model for the system behavior. This circumstance allows for instance the detection of anomalies and the prediction of failures. To do so, a distance metric that considers the current point in time is applied on a test data set of currently acquired data and the cluster centers of the trained model. Anomalies in the test data set are detected by defined time-dependent limit violations to the cluster centers as well as the emergence of new, previously non-existent clusters. Thus, the slinking emergence of failure can be predicted based on the frequency of anomaly occurrences and their intensity of deviation.

As a further embodiment example, the digital risk twin 4 can e.g. be applied to automated risk-transfer and risk exposure measuring systems. Also in this example, the digital representation of the risks related to a specific real world asset or object 3. The digital platform allows the generation of signaling giving a quantification measure of risks, e.g. with appropriate numbers and graphs. The digital platform 1 thus comprises automated risk assessment and measuring and risk scoring capabilities based on the measured risks, i.e. probability measures for the occurrence of a predefined risk event with an associated loss. The digital platform 1 is able to measure the risk impact on a much larger scale (i.e. engine > plant > supply chain) by means of the digital risk twin 4. The digital risk twin 4 has further the advantage that it can be completely digitally created/managed. It allows to extend the risk-transfer technology for risk based data services, and provides an easy access to asset/object 3 related insights/analytics by means of the digital risk twin 4. Further, it allows to provide normalization of risk factors and values, as described above, and is easy to integrate in other processes/value chains.

The twinned real world entity can be a physical or intangible asset 31/32 or a living object 33, e.g. a human being 331 or an animal 332. The complete digital platform 1 can be used on digital twins (IoT) and appropriate data feeds. The digital platform 1 can e.g. be realized in the sense of a risk intelligence factory creating the digital risk twin 4 by applying a company's intelligence (risk, actuarial, Machine Learning, etc.) to data assets. In contrast to the digital twin 47, which uses data from loT sensors, physical modelling structures of the real-world device/asset/object 3 providing time-dependent measures for the performance and/or status etc., the digital risk twin 45 captures and measures data from multiple sources comprising ecosystem measuring parameters and involves a risk modelling structure of the real-world asset/object 3 and the environment, which allow to effectively measure and trigger risk-related factors, as e.g. exposure measures or occurrence probabilities of risk-events or impact measures under the occurrence of a certain event with a certain strength or physical characteristic. Thus, it allows inter alia to effectively optimize and minimize risk impacts, respectively.

The recording of the analysis-measurement data, i.e. the stream of measuring parameters measured by the sensors and/or measuring devices associated with the twinned object/asset allows the realization of the replay function according to the invention (therefore the designation of the analysis-measurement data also as replay data; cf. above). The replay function is intended as a specific embodiment of the system according to the invention. It can be realized with and without the above discussed optimization function, i.e. with and without adjusting the digital twin parameters or with or without adjusting operational/structural/environmental parameters of the twinned object/asset by means of the electronic signaling system control based on the output values of the machine-learning unit. In principle, the recording of the analysis-measurement data can be triggered by the detection of a first and/or second event (e.g. detected by its anomaly or significance) of the time series. Figure 9 shows such a replay embodiment with provision of analysis measurement data (as replay data) for monitoring a time period in the replay mode of the digital twin and/or twinned object/asset. The analysis measurement data are recorded, for example, on a storage medium of a server (S). By means of an assembly (BG) comprising a client for time-shifted retrieval of analysis measurement data, a time-shifted to real-time section of the replay data is selected, e.g., by means of a time tag (time-based tagging) or an event area displayed by the system to the user for selection, and requested, e.g., by means of a request from server S. The server S provides the requested time section to the user. The latter compiles the requested time section of the replay data in the form of multimedia data packets and transmits them over the network to the client of the assembly. The client unpacks the multimedia data packets and displays them for the user on the monitor (M). The assembly with the client can be part of the server S, e.g. implemented as part of the system control, or as a network assembly which can access the server S or the system control with integrated server S via the network N. Figure 10 shows a time data set diagram highlighting a time range available for retrieval e.g. including an event detected by the system 1. The entire real time analysis data stream can be recorded or only time ranges of the analysis data stream, i.e. the replay data, in which first and/or second events were detected by the system 1. As shown with the time-dataset diagram highlighting a replay of a past event areas/regions of Figure 11, the embodiment according to the invention can also be implemented in such a way that the user can jump to any point in time in the past of the recorded analysis data stream, i.e. independently of event detections. Also, the user can, e.g., time-delayed beyond a certain time range, retrieve the analysis measurement data from the stored replay data stream, jump forward (forward) or backward (rewind) one time range in the recorded data stream at a time x. Finally, the time-data set diagram of Figure 12 illustrates an exemplary embodiment in which the detected event time ranges are displayed to the user for selection, e.g., via the client on the board. In particular, a further embodiment can be realized in such a way that the connected twinned object/asset respectively the digital twin, can be set again by the electronic system controller to the exact operating mode or status with the same measuring parameters as in the detected event area. The digital twin and/or the connected twinned asset/object can thus be run through the event area again in real time, e.g. for testing, optimization or other verification purposes.

As discussed above, e.g. the whole real-time analysis data stream can be recorded in digital format on the server S, or only the areas with detected, first and/or second events A through H. The server can e.g. also be provided centrally by a provider for the provision of this replay data lying in the past, whereby e.g. an operator of the system can access the server S by means of a secured assembly/computer with corresponding client. The recording is done in such a way that an event range A to H is stored either as a single file or in multiple files each representing an event sub-range. The number of recordings of the replay data areas and the resulting files may vary depending on the number of users who are to have subsequent access to them. Regardless, the number of records of the real-time analysis data stream (replay data streams) may depend on the recording and data delivery technology used. For example, these files, once recorded, may also be retrieved by means of a digital subscriber line or other uniquely assignable data transmission from the BG assembly or other designated receiver with a unique address and played back on a multimedia device MG, such as a monitor or computer. For example, the assembly BG may also be integrated into the corresponding device in the case of a mobile multimedia device, such as a cell phone, a PDA, a tablet PC. Immediately after the real-time recording of the replay data stream, the recorded ranges of the respective detected events or the respective time ranges or set time tags can be retrieved by the user.

In Figure 10, at time tc this event area is completely recorded on the server S and made available for its retrieval. Parts of this event area may already be retrievable immediately after the start of their recording and/or detection, provided they are in the past. The user selecting this event area receives this event area C in digital format displayed in real time on the monitor MG via the client of the assembly. As Figure 11 shows, pausing, rewinding or forwarding (if a past portion of the replay data stream has been accessed) may also be possible for monitoring the replay data stream via the client. All following time ranges of the replay data stream run for the user then e.g. when pausing by the length of the pause, time-shifted to the real time replay data stream. It is of course possible for the user to jump back to the real time mode of monitoring the analysis data stream at any time. In this case, parts of the replay data stream are skipped again accordingly. For already detected event areas of the replay data stream, it is also possible to download the desired event area A-H as a file and then view it. However, the download time can be very time-consuming depending on the available bandwidth for data transfer. Furthermore, the download time can be significantly extended if additional event areas or the real-time stream are viewed/monitored at the same time. In general, the replay embodiment may be designed, for example, to use a new method for providing replay data via an assembly BG associated with a multimedia device MG having a corresponding client. The entire replay data stream is recorded on the server S. As an embodiment, also only the detected first and/or second event regions can be stored. Then the steps are performed: a) selecting, by means of the client supported by the assembly (BG), one or more event areas and/or time ranges and/or selectable time tags or time markers in the stored replay data stream at the multimedia device (MG); b) retrieving, based on the previous selection, one or more time ranges based on their unique identification (in terms of time or content (e.g. detected anomalies or replay data ranges filtered by means of a filter through entered characteristic parameters)). During the transmission also several multimedia data files could represent in each case an event/time range and their markings thereby in each case an unambiguously subrange-specific marking covers to the call of the server (S) on in each case the time/anomaly ranges (A to H) is stored; c) providing a time range of the recorded replay data stream stored in the data files at the multimedia device (MG) starting with the selected event range or sub-range with a time delay which is at least as large as the difference between the actual real-time analysis data stream and the selection time (see Figures 10-12).

### List of reference signs

1 Digital Platform
   10 Data Store
   101,...,105 Modular Digital Assets/Objects Data Elements
2 loT Sensory (input devices and sensors)
3 Real-world Asset or Object
   31 Physical Asset
   32 Intangible Asset
   33 Living Object
      331 Human Being
      332 Animal
   34 Subsystems of the Real-world Asset or Object
      341, 342, 343,..., 34i Subsystems 1,...,i
   35 Subsystems and Components of the Ecosystem
      351, 352, 353,..., 35i Subsystems 1,...,i
4 Digital Risk Twin (autonomous)
   41 Digital Intelligence Layer
      411 Machine Learning
      412 Neural Network
   42 Property Parameters of Real-World Asset or Object
   43 Status Parameters of Real-World Asset or Object
      431 Structural Status Parameters
      432 Operational Status Parameters
      433 Environmental Status Parameters
   44 Data Structures Representing States of Each of the Plurality of Subsystems of the Real-World Asset or Object
   45 Digital Risk Twin
      451 Simulation
      452 Synchronization
      453 Twin Linking: Sensory/Measuring/Data Acquisition
   46 Digital Ecosystem Replica Layer
      461, 462, 463,..., 46i Virtual Subsystems of Twinned Ecosystem
   47 Digital Twin
      471 Simulation
      472 Synchronization
      473 Twin Linking: Sensory/Measuring/Data Acquisition
   48 Digital Asset/Object Replica Layer
      481, 482, 483,..., 48i Virtual Subsystems of Twinned Real-World Asset/Object
5 Ecosystem - Environment - Interaction between Real-world Assets/Objects

## Claims

1. Method for a digital platform (1) for avatar measurements of temporally evolving risk-based real-world measuring parameters, the digital platform (1) comprising measuring sensors (2) associated with a specific physical real-world technical system (3) including industrial plants with electro-mechanical systems, aircraft engines or mill plants to be monitored, wherein the digital platform (1) comprises a data store (10) with stored modular digital object data elements (101,...,105) each representing subsystems (41) of the real-world technical system (3) for the assembly of a digital twin representation (4) of the physical real-world technical system (3, and wherein the modular digital object data elements (101,...,105) are selected and assembled to said digital twin representation (4) from the data store (10) based on captured structural (421), operational (422) and environmental (423) property parameters (42) by means of the digital platform (1), wherein,
by means of the sensors (2) associated with the twinned physical technical system (3), structural (431), operational (432) and environmental (433) status parameters (43) of the real-world technical system (3) are measured, monitored, and transmitted to the digital platform (1), wherein the sensors (2) comprise one or more associated exteroceptive sensors (2) for sensing exogen environmental parameters physically impacting the real-world technical system (3) and one or more proprioceptive sensors (2) for sensing endogen operating parameters of the real-world technical system (3), wherein one or more wireless connections are set by interfaces of the sensors (2) between the digital platform (1) and the sensors (2), wherein data links are set by means of the wireless connections between the digital platform (1) and the sensors (2) transmitting the status parameters (43) measured by the sensors (2) to the digital platform (1), wherein the measured status parameters (43) are assigned to the digital twin representation (4), the values of the status parameters (43) associated with the digital twin representation (4) being dynamically monitored and adapted based on the transmitted parameters (43), and wherein the digital twin representation (4) comprises data structures (44) representing states (441) of each of the plurality of subsystems (41) of the real-world technical system (3) holding the values of the status parameters (43) as a time series of a time period,
in that, by means of the digital platform (1), data structures (44) for the digital twin representation (4) representing future states (441) of each of the plurality of subsystems (41) of the real-world technical system (3) are generated as value time series over a future time period based on an application of simulations using cumulative damage modelling processing, the cumulative damage modelling generating the effect of the operational and environmental object status parameters (43) on the twinned real-world technical system (3) of the future time period,
in that, by means of the digital platform (1), the digital twin representation (4) is analyzed providing a measure for a future state of the twinned real-world technical system (3) based on the generated value time series of values over said future time period, the measure being related to the probability of the occurrence of a predefined physical event with a certain strength or physical characteristic physically impacting the real-world technical system (3), wherein the physically measurable probability measure for the occurrence of the predefined physical event is established based on frequency and severity of historical measuring data of the predefined physical event by means of a predicting machine learning module using the measured time series of status parameters (43) values,
in that for generating the probability of the occurrence of a predefined physical event impacting the real-world technical system (3), a cumulative damage modelling is performed by the machine learning module comprising a first step of detecting first anormal or significant effects within the generated and measured time series of parameter values, wherein the detection of anomaly and significant events is triggered by exceeding a measured deviation from a defined threshold value per single or set of operational and environmental object parameters, and comprising a second step of detecting second anomaly and significant events based on the generated and measured time series of parameter values, wherein by means of dynamic time normalization a topological distance between the measured time series of the parameter values (43) over a time is determined as a distance matrix, wherein a measured time series signal of detected event rates are matched as spectral or cepstral value tuples with other value tuples of measured time series signal of event rates, and wherein using a weighting for the individual parameters (43) of each measured value tuple, a difference measure between any two values of the two signals is established, the digital platform (1) searching for a most favorable path from beginning to end of both signals via the spanned distance matrix of the pairwise distances of all points of both signals, and
in that a control of an operation or status of the real world technical system (3) is optimized or adjusted to predefined operational and/or status object parameters (43) of the specific real-world technical system (3) based on the provided measure for a future state of the twinned real-world technical system (3), wherein in case of an optimized or adjusted control of operation, the optimized control of operation is optimized or adjusted to jointly and severally increase the specific operating performance criteria in time and future of the real-world technical system (3) or decrease a measure for an occurrence probability associated with the status of the real-world technical system (3) within a specified probability range.

2. Method for a digital platform (1) for avatar measurements of evolving real-world measuring parameters according to claim 1, **characterized in that** the decrease of the measure for an occurrence probability associated with the operation or status of the real-world technical system (3) is based on a transfer of risk to an automated risk-transfer system controlled by the digital platform, wherein values of parameters characterizing the transfer of risk are optimized based on said measure for a future state or operation of the twinned real-world technical system (3) and/or based on the generated value time series of values over said future time period.

3. Method for a digital platform (1) for avatar measurements of evolving real-world measuring parameters according to claim 1, **characterized in that** in order to optimize the status of the real-world technical system (3) or the probability of an occurrence of a predefined risk event, an optimizing adjustment of at least a subsystem (34) of the real-world technical system (3) is triggered by means of the digital platform (1).

4. Method for a digital platform (1) for avatar measurements of evolving real-world measuring parameters according to claim 3, **characterized in that** the triggering by means of the digital platform (1) is performed by electronic signal transfer.

5. Method for a digital platform (1) for avatar measurements of evolving real-world measuring parameters according to one of the claims 1 to 4, **characterized in that**, based on the measure for a future state or operation of the twinned real-world technical system (3), a forecasted measure of an occurrence probability of one or more predefined risk events impacting the real-world technical system (3) is generated by propagating the parameters of the digital twin representation (4) in controlled time series.

6. Method for a digital platform (1) for avatar measurements of evolving real-world measuring parameters according to one of the claims 1 to 5, **characterized in that** the operational and/or environmental parameters comprise endogen parameters, whose values are determined by the real-world technical system (3), and/or exogen parameters, whose values origin from and are determined outside the real-world technical system (3) and are imposed on the real-world technical system (3).

7. Method for a digital platform (1) for avatar measurements of evolving real-world measuring parameters according to claim 6, **characterized in that** the digital platform (1) comprises associated exteroceptive sensors or measuring devices (2) for sensing exogen environmental parameters physically impacting the real-world technical system (3) and proprioceptive sensors or measuring devices (2) for sensing endogen operating or status parameters of the real-world technical system (3).

8. Method for a digital platform (1) for avatar measurements of evolving real-world measuring parameters according to one of the claims 6 or 7, **characterized in that** the sensors or measuring devices (2) comprise interfaces for setting one or more wireless or wired connections between the digital platform (1) and the sensors or measuring devices (2), wherein data links are settable by means of the wireless or wired connections between the digital platform (1) and the sensors or measuring devices (2) associated with the real-world technical system (3) transmitting the exogen and endogen parameters measured and/or captured by the sensors or measuring devices (2) to the digital platform (1).

9. Method for a digital platform (1) for avatar measurements of evolving real-world measuring parameters according to one of the claims 1 to 8, **characterized in that** the digital platform comprises and triggers an automated expert system of the digital platform (1) by means of electronic signal transfer, wherein the digital platform (1) triggers the transmission of a digital recommendation to a user interface generated by the expert system of the digital platform based on the measured value of the measure for a future state or operation of the twinned real-world technical system (3) and/or the measured probability of the occurrence of a predefined physical event to the real-world technical system (3), and wherein the digital recommendation comprises indications for an optimization of the real-world technical system (3) or adaption of the structural, operational and/or environmental status parameters.

10. Method for a digital platform (1) for avatar measurements of evolving real-world measuring parameters according to one of the claims 1 to 9, **characterized in that** the method comprises the further steps of measuring relative parameter deviations given by the measured deviation of a mean value over a unit of time of the measuring parameters per parameter or parameters of a digital twin element from a target parameter value, measuring associated frequency distributions of the scaled relative measuring deviations per parameter or parameters of a digital twin element, measuring rates over time per element of the digital twin as a time series of measured values of rates, and measuring time frame speeds as a function of time per element of the digital twin.

11. Digital platform (1) for avatar measurements of temporally evolving risk-based real-world measuring parameters, the digital platform (1) comprising measuring (2) associated with a specific physical real-world technical system (3) including industrial plants with electro-mechanical systems, aircraft engines or mill plants to be monitored, wherein the digital platform (1) comprises a data store (10) storing modular digital objects data elements (101,...,105) each representing subsystems (14) of the real-world technical system (3) for the assembly of a digital twin representation (4) of the physical real-world technical system (3), and wherein the modular digital objects data elements (101,...,105) are selectable to be assembled to said digital twin representation (4) from the data store (10) based on captured structural (421), operational (422) and environmental (423) property parameters (42) by means of the digital platform (1), wherein,
the sensors (2) associated with the twinned physical technical system (3) are configured to measure, monitor and transmit structural (431), operational (432) and environmental (433) status parameters (43) of the real-world technical system (3) to the digital platform (1) to be associated to the digital twin representation (4), wherein the sensors (2) comprise one or more associated exteroceptive sensors (2) for sensing exogen environmental parameters physically impacting the real-world technical system (3) and one or more proprioceptive sensors (2) for sensing endogen operating parameters of the real-world technical system (3), wherein the sensors or measuring devices (2) comprise interfaces for setting one or more wireless connections between the digital platform (1) and the sensors (2), wherein the wireless connections between the digital platform (1) and the sensors (2) are configured to set data links associated with the real-world technical system (3) transmitting the status parameters (43) measured by the sensors (2) to the digital platform (1), wherein the values of the measured status parameters (43) associated with the digital twin representation (4) are dynamically monitored and adapted based on the transmitted parameters (43), and wherein the digital twin representation (4) comprises data structures (44) representing states (441) of each of the plurality of subsystems (41) of the real-world technical system (3) holding the values of the status parameters (43) as a time series of a time period,
in that the digital platform (1) is configured to generate data structures (44) for the digital twin representation (4) representing future states (441) of each of the plurality of subsystems (41) of the real-world technical system (3) as value time series over a future time period based on an application of simulations using cumulative damage models, the cumulative damage models generating the effect of the operational and environmental object status parameters (43) on the twinned real-world technical system (3) of the future time period,
in that the digital platform (1) is configured to analyze the digital twin representation (4) providing a measure for a future state of the twinned real-world technical system (3) based on the generated value time series of values over said future time period, the measure being related to the probability of the occurrence of a predefined physical event with a certain strength or physical characteristic physically impacting the real-world technical system (3), wherein the physically measurable probability measure for the occurrence or development of the predefined physical event is established based on frequency and severity of historical measuring data of the predefined physical event by means of a predicting machine learning module using the measured time series of status parameters (43) values,
in that for generating the probability of the occurrence of a predefined physical event impacting the real-world technical system (3), a cumulative damage modelling is performed by the machine learning module comprising a first step of detecting first anormal or significant effects within the generated and measured time series of parameter values, wherein the detection of anomaly and significant events is triggered by exceeding a measured deviation from a defined threshold value per single or set of operational and environmental object parameters, and comprising a second step of detecting second anomaly and significant events based on the generated and measured time series of parameter values, wherein by means of dynamic time normalization a topological distance between the measured time series of the status parameter (43) values over a time is determined as a distance matrix, wherein a measured time series signal of detected event rates are matched as spectral or cepstral value tuples with other value tuples of measured time series signal of event rates, and wherein using a weighting for the individual parameters (43) of each measured value tuple, a difference measure between any two values of the two signals is established, the digital platform (1) searching for a most favorable path from beginning to end of both signals via the spanned distance matrix of the pairwise distances of all points of both signals, and
in that a control of an operation or status of the real world technical system (3) is optimizable or adjustable to predefined operational and/or status object parameters of the specific real-world technical system (3) based on the provided measure for a future state of the twinned real-world technical system (3), wherein in case of an optimized control of operation, the optimized control of operation is generated to jointly and severally increase the specific operating performance criteria in time and future of the real-world technical system (3) or decrease a measure for an occurrence probability associated with the status of the real-world technical system (3) within a specified probability range.

12. Digital platform (1) for avatar measurements of evolving real-world measuring parameters according to claim 11, **characterized in that** the decrease of the measure for an occurrence probability associated with the operation or status of the real-world technical system (3) is based on a transfer of risk to an automated risk-transfer system controlled by the digital platform, wherein values of parameters characterizing the transfer of risk are optimized based on said measure for a future state or operation of the twinned real-world technical system (3) and/or based on the generated value time series of values over said future time period.

13. Digital platform (1) for avatar measurements of evolving real-world measuring parameters according to claim 11, **characterized in that** in order to optimize the status of the real-world technical system (3) or the probability of an occurrence of a predefined risk event, an optimizing adjustment of at least a subsystem (34) of the real-world technical system (3) is triggered by means of the digital platform (1).

14. Digital platform (1) for avatar measurements of evolving real-world measuring parameters according to claim 13, **characterized in that** the triggering by means of the digital platform (1) is performed by electronic signal transfer.

15. Digital platform (1) for avatar measurements of evolving real-world measuring parameters according to one of the claims 11 to 14, **characterized in that**, based on the measure for a future state or operation of the twinned real-world technical system (3), a forecasted measure of an occurrence probability of one or more predefined risk events impacting the real-world technical system (3) is generated by propagating the parameters of the digital twin representation (2) in controlled time series.

16. Digital platform (1) for avatar measurements of evolving real-world measuring parameters according to one of the claims 11 to 15, **characterized in that** the operational and/or environmental parameters comprise endogen parameters, whose values are determined by the real-world technical system (3), and/or exogen parameters, whose values origin from and are determined outside the real-world technical system (3) and are imposed on the real-world technical system (3).

17. Digital platform (1) for avatar measurements of evolving real-world measuring parameters according to claim 16, **characterized in that** the digital platform comprises associated exteroceptive sensors or measuring devices (2) for sensing exogen environmental parameters physically impacting the real-world technical system (3) and proprioceptive sensors or measuring devices (2) for sensing endogen operating or status parameters of the real-world technical system (3).

18. Digital platform (1) for avatar measurements of evolving real-world measuring parameters according to one of the claims 16 or 17 **characterized in that** the sensors or measuring devices (2) comprise interfaces for setting one or more wireless or wired connections between the digital platform (1) and the sensors or measuring devices (2), wherein data links are settable by means of the wireless or wired connections between the digital platform (1) and the sensors or measuring devices (2) associated with the real-world technical system (3) transmitting the exogen and endogen parameters measured and/or captured by the sensors or measuring devices (2) to the digital platform (1).

19. Digital platform (1) for avatar measurements of evolving real-world measuring parameters according to one of the claims 11 to 18, **characterized in that** the digital platform (1) comprises and triggers an automated expert system of the digital platform (1) by means of electronic signal transfer, wherein the digital platform (1) triggers the transmission of a digital recommendation to a user interface generated by the expert system of the digital platform based on the measured value of the measure for a future state or operation of the twinned real-world technical system (3) and/or the measured probability of the occurrence of a predefined physical event to the real-world technical system (3), and wherein the digital recommendation comprises indications for an optimization of the real-world technical system (3) or adaption of the structural, operational and/or environmental status parameters.

## Patentansprüche

1. Verfahren für eine digitale Plattform (1) für Avatar-Messungen sich zeitlich entwickelnder risikobasierter Messparameter der realen Welt, wobei die digitale Plattform (1) Messsensoren (2) umfasst, die einem spezifischen physischen technischen System (3) der realen Welt zugeordnet sind, das Industrieanlagen mit elektromechanischen Systemen, Luftfahrzeugtriebwerke oder Mühlenanlagen, die überwacht werden sollen, beinhaltet, wobei die digitale Plattform (1) einen Datenspeicher (10) mit gespeicherten modularen digitalen Objektdatenelementen (101, ..., 105) umfasst, die jeweils Teilsysteme (41) des technischen Systems (3) der realen Welt für das Zusammenfügen einer Darstellung (4) des digitalen Zwillings des physischen technischen Systems (3) der realen Welt umfassen, und wobei die modularen digitalen Objektdatenelemente (101, ..., 105) und zur Darstellung (4) des digitalen Zwillings aus dem Datenspeicher (10) ausgewählt und basierend auf aufgenommenen Struktur- (421), Betriebs-(422) und umgebungsbezogenen (423) Eigenschaftsparametern (42) mittels der digitalen Plattform (1) zusammengefügt werden, wobei
mittels der Sensoren (2), die dem mit dem Zwilling versehenen physischen technischen System (3) zugeordnet sind, Struktur- (431), Betriebs- (432) und umgebungsbezogene (433) Zustandsparameter (43) des technischen Systems (3) der realen Welt gemessen, überwacht und an die digitale Plattform (1) übertragen werden, wobei die Sensoren (2) einen oder mehrere zugeordnete exterozeptive Sensoren (2) zum Abtasten exogener Umgebungsparameter umfassen, die sich auf das technische System (3) der realen Welt physisch auswirken, und einen oder mehrere propriozeptive Sensoren (2) zum Abtasten endogener Betriebsparameter des technischen Systems (3) der realen Welt, wobei eine oder mehrere drahtlose Verbindungen durch Schnittstellen der Sensoren (2) zwischen der digitalen Plattform (1) und den Sensoren (2) eingerichtet sind, wobei Datenverknüpfungen mittels der drahtlosen Verbindungen zwischen der digitalen Plattform (1) und den Sensoren (2) eingestellt sind, die die Zustandsparameter (43), die von den Sensoren (2) gemessen werden, an die digitale Plattform (1) übertragen, wobei die gemessenen Zustandsparameter (43) der Darstellung (4) des digitalen Zwillings zugewiesen werden, wobei Werte der Zustandsparameter (43), die der Darstellung (4) des digitalen Zwillings zugeordnet sind, dynamisch überwacht und basierend auf den übertragenen Parametern (43) angepasst werden, und wobei die Darstellung (4) des digitalen Zwillings Datenstrukturen (44) umfasst, die Zustände (441) jedes der Vielzahl von Teilsystemen (41) des technischen Systems (3) der realen Welt umfassen, die die Werte der Zustandsparameter (43) als eine zeitliche Folge eines Zeitraums enthalten,
dass mittels der digitalen Plattform (1) Datenstrukturen (44) für die Darstellung (4) des digitalen Zwillings, die zukünftige Zustände (441) jedes der Vielzahl von Teilsystemen (41) des technischen Systems (3) der realen Welt darstellen, als Wertzeitreihe über einen zukünftigen Zeitraum basierend auf einer Anwendung von Simulationen unter Verwendung einer Modellierungsverarbeitung für kumulative Schäden erzeugt werden, wobei die Modellierung kumulativer Schäden die Auswirkung der Betriebs- und umgebungsbezogenen Objektzustandsparameter (43) auf das mit einem digitalen Zwilling versehene technische System (3) der realen Welt des zukünftigen Zeitraums erzeugt,
dass mittels der digitalen Plattform (1) die Darstellung (4) des digitalen Zwillings analysiert wird, indem ein Maß für einen zukünftigen Zustand des mit dem digitalen Zwilling versehenen technischen Systems (3) der realen Welt über den zukünftigen Zeitraum, basierend auf der erzeugten Wertzeitreihe von Werten bereitgestellt wird, wobei das Maß die Wahrscheinlichkeit des Auftretens eines vordefinierten physischen Ereignisses mit einer bestimmten Stärke oder einem bestimmten physikalischen Merkmal, das sich physisch auf das technische System (3) der realen Welt auswirkt, betrifft, wobei das physikalisch messbare Wahrscheinlichkeitsmaß für das Auftreten des vordefinierten physischen Ereignisses basierend auf Häufigkeit und Schwere historischer Messdaten des vordefinierten physischen Ereignisses mittels eines prädiktiven maschinellen Lernmoduls unter Verwendung der gemessenen Zeitreihe von Werten der Zustandsparameter (43) erstellt wird,
dass zum Erzeugen der Wahrscheinlichkeit des Auftretens eines vordefinierten physischen Ereignisses, das sich auf das technische System (3) der realen Welt auswirkt, eine Modellierung kumulativer Schäden von dem maschinellen Lernmodul durchgeführt wird, die einen ersten Schritt des Erfassens erster anormaler oder signifikanter Auswirkungen innerhalb der erzeugten und gemessenen Zeitreihe von Parameterwerten umfasst, wobei die Erfassung von Anomalie und signifikanten Ereignissen durch Überschreiten einer gemessenen Abweichung von einem definierten Schwellenwert pro einzelnem oder einem Satz von Betriebs- und umgebungsbezogenen Objektparametern ausgelöst wird, und einen zweiten Schritt des Erfassens zweiter Anomalie und signifikanter Ereignisse basierend auf der erzeugten und gemessenen Zeitreihe von Parameterwerten umfasst, wobei mittels dynamischer Zeitnormalisierung ein topologischer Abstand zwischen der gemessenen Zeitreihe der Parameterwerte (43) über eine Zeit als eine Abstandsmatrix bestimmt wird, wobei ein gemessenes Zeitreihensignal erfasster Ereignisraten als spektrale oder cepstrale Werttupel mit anderen Wertetupeln von gemessenem Zeitreihensignal von Ereignisraten abgestimmt wird, und wobei unter Verwendung von Gewichtung für die individuellen Parameter (43) jedes gemessenen Wertetupels ein Differenzmaß zwischen beliebigen zwei Werten der beiden Signale erstellt wird, wobei die digitale Plattform (1) nach einem günstigsten Pfad vom Anfang zum Ende beider Signale über die aufgespannte Abstandsmatrix der paarweisen Abstände aller Punkte beider Signale sucht, und
dass eine Steuerung eines Betriebs oder Zustands des technischen Systems (3) der realen Welt auf vordefinierte Betriebs- und/oder Zustandsobjektparameter (43) des spezifischen technischen Systems (3) der realen Welt basierend auf dem bereitgestellten Maß für einen zukünftigen Zustand des mit einem digitalen Zwilling versehenen technischen Systems (3) der realen Welt optimiert oder angepasst wird, wobei im Fall einer optimierten oder angepassten Betriebssteuerung die optimierte Betriebssteuerung optimiert oder angepasst wird, um die spezifischen Betriebsleistungskriterien des technischen Systems (3) der realen Welt gemeinsam und jeweils über die Zeit und für die Zukunft zu erhöhen, oder ein dem Zustand des technischen Systems (3) der realen Welt zugeordnetes Maß für eine Auftrittswahrscheinlichkeit innerhalb eines spezifizierten Wahrscheinlichkeitsbereichs zu verringern.

2. Verfahren für eine digitale Plattform (1) für Avatar-Messungen sich entwickelnder Messparameter der realen Welt nach Anspruch 1,
**dadurch gekennzeichnet, dass** die Verringerung des Maßes für eine Auftrittswahrscheinlichkeit, die dem Betrieb oder Zustand des technischen Systems (3) der realen Welt zugeordnet ist, auf einem Risikotransfer auf ein automatisiertes Risikotransfersystem basiert, das von der digitalen Plattform gesteuert wird, wobei Werte von Parametern, die den Risikotransfer charakterisieren, basierend auf dem Maß für einen zukünftigen Zustand oder Betrieb des mit einem Zwilling versehenen technischen Systems (3) der realen Welt und/oder basierend auf der erzeugten Wertzeitreihe von Werten über den zukünftigen Zeitraum optimiert werden.

3. Verfahren für eine digitale Plattform (1) für Avatar-Messungen sich entwickelnder Messparameter der realen Welt nach Anspruch 1,
**dadurch gekennzeichnet, dass** zum Optimieren des Zustands des technischen Systems (3) der realen Welt oder der Wahrscheinlichkeit eines Auftretens eines vordefinierten Risikoereignisses eine Optimierungseinstellung mindestens eines Teilsystems (34) des technischen Systems (3) der realen Welt mittels der digitalen Plattform (1) ausgelöst wird.

4. Verfahren für eine digitale Plattform (1) für Avatar-Messungen sich entwickelnder Messparameter der realen Welt nach Anspruch 3,
**dadurch gekennzeichnet, dass** das Auslösen mittels der digitalen Plattform (1) durch elektronischen Signaltransfer durchgeführt wird.

5. Verfahren für eine digitale Plattform (1) für Avatar-Messungen sich entwickelnder Messparameter der realen Welt nach einem der Ansprüche 1 bis 4,
**dadurch gekennzeichnet, dass** basierend auf dem Maß für einen zukünftigen Zustand oder Betrieb des mit einem Zwilling versehenen technischen Systems (3) der realen Welt ein prognostiziertes Maß eine Auftrittswahrscheinlichkeit eines oder mehrerer vordefinierter Risikoereignisse, die sich auf das technische System (3) der realen Welt auswirken, durch Propagieren der Parameter der Darstellung (4) des digitalen Zwillings in gesteuerten Zeitreihen erzeugt wird.

6. Verfahren für eine digitale Plattform (1) für Avatar-Messungen sich entwickelnder Messparameter der realen Welt nach einem der Ansprüche 1 bis 5,
**dadurch gekennzeichnet, dass** die Betriebs- und/oder Umgebungsparameter endogene Parameter umfassen, deren Werte von dem technischen System (3) der realen Welt bestimmt werden, und/oder exogene Parameter, deren Werte von außerhalb des technischen Systems (3) der realen Welt stammen und dort bestimmt werden und dem technischen System (3) der realen Welt auferlegt werden.

7. Verfahren für eine digitale Plattform (1) für Avatar-Messungen sich entwickelnder Messparameter der realen Welt nach Anspruch 6,
**dadurch gekennzeichnet, dass** die digitale Plattform (1) zugeordnete exterozeptive Sensoren oder Messvorrichtungen (2) zum Abtasten exogener Umgebungsparameter umfasst, die sich auf das technische System (3) der realen Welt physisch auswirken, und propriozeptive Sensoren oder Messvorrichtungen (2) zum Abtasten endogener Betriebs- oder Zustandsparameter des technischen Systems (3) der realen Welt.

8. Verfahren für eine digitale Plattform (1) für Avatar-Messungen sich entwickelnder Messparameter der realen Welt nach einem der Ansprüche 6 oder 7,
**dadurch gekennzeichnet, dass** die Sensoren oder Messvorrichtungen (2) Schnittstellen zum Einstellen einer oder mehrerer drahtloser oder drahtgebundener Verbindungen zwischen der digitalen Plattform (1) und den Sensoren oder Messvorrichtungen (2) umfassen, wobei Datenverknüpfungen mittels der drahtlosen oder drahtgebundenen Verbindungen zwischen der digitalen Plattform (1) und den Sensoren oder Messvorrichtungen (2) einstellbar sind, die dem technischen System (3) der realen Welt zugeordnet sind, die die exogenen und endogenen Parameter, die von den Sensoren oder Messvorrichtungen (2) gemessen und/oder aufgenommen werden, an die digitale Plattform (1) übertragen.

9. Verfahren für eine digitale Plattform (1) für Avatar-Messungen sich entwickelnder Messparameter der realen Welt nach einem der Ansprüche 1 bis 8,
**dadurch gekennzeichnet, dass** die digitale Plattform ein automatisiertes Expertensystem der digitalen Plattform (1) umfasst und mittels elektronischem Signaltransfer auslöst, wobei die digitale Plattform (1) die Übertragung einer digitalen Empfehlung an eine Benutzeroberfläche auslöst, von dem Expertensystem der digitalen Plattform basierend auf dem gemessenen Wert des Maßes für einen zukünftigen Zustand oder Betrieb des mit einem Zwilling versehenen technischen System (3) der realen Welt und/oder der gemessenen Wahrscheinlichkeit des Auftretens eines vordefinierten physischen Ereignisses an dem technischen System (3) der realen Welt erzeugt wird, und wobei die digitale Empfehlung Angaben für eine Optimierung des technischen Systems (3) der realen Welt oder Anpassung der Struktur-, Betriebs- und/oder umgebungsbezogene Zustandsparameter umfasst.

10. Verfahren für eine digitale Plattform (1) für Avatar-Messungen sich entwickelnder Messparameter der realen Welt nach einem der Ansprüche 1 bis 9,
**dadurch gekennzeichnet, dass** das Verfahren die zukünftigen Schritte des Messens relativer Parameterabweichungen, die durch die gemessene Abweichung eines Mittelwerts über eine Zeiteinheit der Messparameter pro Parameter oder Parametern eines digitalen Zwillingselements aus einem Zielparameterwert gegeben werden, Messen zugeordneter Frequenzverteilungen der skalierten relativen Messabweichungen pro Parameter oder Parametern eines digitalen Zwillingselements, Messraten über Zeit pro Element des digitalen Zwillings als eine Zeitreihe gemessener Werte von Raten, und Messzeitrahmengeschwindigkeiten als eine Funktion von Zeit pro Element des digitalen Zwillings umfasst.

11. Digitale Plattform (1) für Avatar-Messungen sich zeitlich entwickelnder risikobasierter Messparameter der realen Welt, wobei die digitale Plattform (1) Messsensoren (2) umfasst, die einem spezifischen physischen technischen System (3) der realen Welt zugeordnet sind, das Industrieanlagen mit elektromechanischen Systemen, Luftfahrzeugtriebwerke oder Mühlenanlagen, die überwacht werden sollen, umfasst, wobei die digitale Plattform (1) einen Datenspeicher (10) umfasst, der modulare digitale Objektdatenelemente (101, ..., 105) speichert, die jeweils Teilsysteme (14) des technischen Systems (3) der realen Welt für das Zusammenfügen einer Darstellung (4) eines digitalen Zwillings des physischen technischen Systems (3) der realen Welt umfassen, und wobei die modularen digitalen Objektdatenelemente (101, ..., 105) auswählbar sind, um zur Darstellung (4) des digitalen Zwillings aus dem Datenspeicher (10) basierend auf aufgenommenen Struktur- (421), Betriebs-(422) und umgebungsbezogenen (423) Eigenschaftsparametern (42) mittels der digitalen Plattform (1) zusammengefügt zu werden, wobei
die Sensoren (2), die dem physischen technischen System (3) zugeordnet sind, dazu konfiguriert sind, Struktur-(431), Betriebs- (432) und umgebungsbezogene (433) Zustandsparameter (43) des technischen Systems (3) der realen Welt zu messen, überwachen und an die digitale Plattform (1) zu übertragen, um der Darstellung (4) des digitalen Zwillings zugeordnet zu sein, wobei die Sensoren (2) einen oder mehrere zugeordnete exterozeptive Sensoren (2) zum Abtasten exogener Umgebungsparameter umfassen, die sich physisch auf das technische System (3) der realen Welt auswirken, und einen oder mehrere propriozeptive Sensoren (2) zum Abtasten endogener Betriebsparameter des technischen Systems (3) der realen Welt, wobei die Sensoren oder Messvorrichtungen (2) Schnittstellen zum Einrichten einer oder mehrere drahtloser Verbindungen zwischen der digitalen Plattform (1) und den Sensoren (2) umfassen, wobei die drahtlosen Verbindungen zwischen der digitalen Plattform (1) und den Sensoren (2) dazu konfiguriert sind, Datenverknüpfungen einzurichten, die dem technischen System (3) der realen Welt zugeordnet sind, das die Zustandsparameter (43), die von den Sensoren (2) gemessen werden, an die digitale Plattform (1) überträgt, wobei die Werte der gemessenen Zustandsparameter (43), die der Darstellung (4) des digitalen Zwillings zugeordnet sind, dynamisch überwacht und basierend auf den übertragenen Parametern (43) angepasst werden, und wobei die Darstellung (4) des digitalen Zwillings Datenstrukturen (44) umfasst, die Zustände (441) jedes der Vielzahl von Teilsystemen (41) des technischen Systems (43) der realen Welt darstellen, die die Werte der Zustandsparameter (43) als eine Zeitreihe eines Zeitraums enthalten,
dass die digitale Plattform (1) dazu konfiguriert ist, Datenstrukturen (44) für die Darstellung (4) des digitalen Zwillings zu erzeugen, die zukünftige Zustände (441) jedes der Vielzahl von Teilsystemen (41) des technischen Systems (3) der realen Welt als Wertzeitreihe über einen zukünftigen Zeitraum basierend auf einer Anwendung von Simulationen unter Verwendung von Modellen für kumulative Schäden darzustellen, wobei die Modelle für kumulative Schäden die Auswirkungen der Betriebs- und Umgebungs-Objektzustandsparameter (43) auf das mit einem Zwilling versehene technische System (3) der realen Welt des zukünftigen Zeitraums erzeugen,
dass die digitale Plattform (1) dazu konfiguriert ist, die Darstellung (4) des digitalen Zwillings zu analysieren, indem ein Maß für einen zukünftigen Zustand des mit dem Zwilling versehenen technischen Systems (3) der realen Welt basierend auf der erzeugten Wertzeitreihe von Werten über den zukünftigen Zeitraum bereitgestellt wird, wobei das Maß die Wahrscheinlichkeit des Auftretens eines vordefinierten physischen Ereignisses mit einer bestimmten Stärke oder physischen Eigenschaft betrifft, die sich auf das technische System (3) der realen Welt physisch auswirkt, wobei das physikalisch messbare Wahrscheinlichkeitsmaß für das Auftreten oder die Entwicklung des vordefinierten physischen Ereignisses basierend auf Häufigkeit und Schwere historischer Messdaten des vordefinierten physischen Ereignisses mittels eines prädikativen maschinellen Lernmoduls unter Verwendung der gemessenen Zeitreihe von Werten von Zustandsparametern (43) erstellt wird,
dass zum Erzeugen der Wahrscheinlichkeit des Auftretens eines vordefinierten physischen Ereignisses, das sich auf das technische System (3) der realen Welt auswirkt, eine Modellierung kumulativer Schäden von dem maschinellen Lernmodul durchgeführt wird, die einen ersten Schritt des Erfassens erster anormaler oder signifikanter Auswirkungen innerhalb der erzeugten und gemessenen Zeitreihe von Parameterwerten umfasst, wobei die Erfassung von Anomalie und signifikanten Ereignissen durch Überschreiten einer gemessenen Abweichung von einem definierten Schwellenwert pro einzelnem oder einem Satz von Betriebs- und umgebungsbezogenen Objektparametern ausgelöst wird, und einen zweiten Schritt des Erfassens zweiter Anomalie und signifikanter Ereignisse basierend auf der erzeugten und gemessenen Zeitreihe von Parameterwerten umfasst, wobei mittels dynamischer Zeitnormalisierung ein topologischer Abstand zwischen der gemessenen Zeitreihe der Werte von Zustandsparametern (43) über eine Zeit als eine Abstandsmatrix bestimmt wird, wobei ein gemessenes Zeitreihensignal erfasster Ereignisraten als spektrale oder cepstrale Werttupel mit anderen Wertetupeln von gemessenem Zeitreihensignal von Ereignisraten abgestimmt werden, und wobei unter Verwendung von Gewichtung für die individuellen Parameter (43) jedes gemessenen Wertetupels ein Differenzmaß zwischen beliebigen zwei Werten der beiden Signale erstellt wird, wobei die digitale Plattform (1) nach einem günstigsten Pfad vom Anfang zum Ende beider Signale über die aufgespannte Abstandsmatrix der paarweisen Abstände aller Punkte beider Signale sucht, und
dass eine Steuerung eines Betriebs oder Zustands des technischen Systems (3) der realen Welt auf vordefinierte Betriebs- und/oder Zustandsobjektparameter des spezifischen technischen Systems (3) der realen Welt basierend auf dem bereitgestellten Maß für einen zukünftigen Zustand des mit einem digitalen Zwilling versehenen technischen Systems (3) der realen Welt optimierbar oder anpassbar ist, wobei im Fall einer optimierten Betriebssteuerung die optimierte Betriebssteuerung erzeugt wird, um die spezifischen Betriebsleistungskriterien des technischen Systems (3) der realen Welt gemeinsam und jeweils über die Zeit und für die Zukunft zu erhöhen, oder ein Maß für eine Auftrittswahrscheinlichkeit, die den Zustand des technischen Systems (3) der realen Welt innerhalb eines spezifizierten Wahrscheinlichkeitsbereichs zugeordnet ist, zu verringern.

12. Digitale Plattform (1) für Avatar-Messungen sich entwickelnder Messparameter der realen Welt nach Anspruch 11,
**dadurch gekennzeichnet, dass** die Verringerung des Maßes für eine Auftrittswahrscheinlichkeit, die dem Betrieb oder Zustand des technischen Systems (3) der realen Welt zugeordnet ist, auf einem Risikotransfer an ein automatisiertes Risikotransfersystem basiert, das von der digitalen Plattform gesteuert wird, wobei Werte von Parametern, die den Risikotransfer charakterisieren, basierend auf dem Maß für einen zukünftigen Zustand oder Betrieb des mit einem Zwilling versehenen technischen Systems (3) der realen Welt und/oder basierend auf der erzeugten Wertzeitreihe von Werten über den zukünftigen Zeitraum optimiert werden.

13. Digitale Plattform (1) für Avatar-Messungen sich entwickelnder Messparameter der realen Welt nach Anspruch 11,
**dadurch gekennzeichnet, dass** zum Optimieren des technischen Systems (3) der realen Welt oder der Wahrscheinlichkeit eines Auftretens eines vordefinierten Risikoereignisses eine Optimierungseinstellung mindestens eines Teilsystems (34) des technischen Systems (3) der realen Welt mittels der digitalen Plattform (1) ausgelöst wird.

14. Digitale Plattform (1) für Avatar-Messungen sich entwickelnder Messparameter der realen Welt nach Anspruch 13,
**dadurch gekennzeichnet, dass** das Auslösen mittels der digitalen Plattform (1) durch elektronischen Signaltransfer durchgeführt wird.

15. Digitale Plattform (1) für Avatar-Messungen sich entwickelnder Messparameter der realen Welt nach einem der Ansprüche 11 bis 14,
**dadurch gekennzeichnet, dass** basierend auf dem Maß für einen zukünftigen Zustand oder Betrieb des mit einem Zwilling versehenen technischen Systems (3) der realen Welt ein prognostiziertes Maß eine Auftrittswahrscheinlichkeit eines oder mehrerer vordefinierter Risikoereignisse, die sich auf das technische System (3) der realen Welt auswirken, durch Propagieren der Parameter der Darstellung (2) des digitalen Zwillings in gesteuerten Zeitreihen erzeugt wird.

16. Digitale Plattform (1) für Avatar-Messungen sich entwickelnder Messparameter der realen Welt nach einem der Ansprüche 11 bis 15,
**dadurch gekennzeichnet, dass** die Betriebs- und/oder Umgebungsparameter endogene Parameter umfassen, deren Werte von dem technischen System (3) der realen Wert bestimmt werden, und/oder exogene Parameter, deren Werte von außerhalb des technischen Systems (3) der realen Welt stammen und dort bestimmt werden und dem technischen System (3) der realen Welt auferlegt werden.

17. Digitale Plattform (1) Verfahren für Avatar-Messungen sich entwickelnder Messparameter der realen Welt nach Anspruch 16,
**dadurch gekennzeichnet, dass** die digitale Plattform zugeordnete exterozeptive Sensoren oder Messvorrichtungen (2) zum Abtasten exogener Umgebungsparameter umfasst, die sich auf das technische System (3) der realen Welt physisch auswirken, und propriozeptive Sensoren oder Messvorrichtungen (2) zum Abtasten endogener Betriebs- oder Zustandsparameter des technischen Systems (3) der realen Welt.

18. Digitale Plattform (1) für Avatar-Messungen sich entwickelnder Messparameter der realen Welt nach einem der Ansprüche 16 oder 17,
**dadurch gekennzeichnet, dass** die Sensoren oder Messvorrichtungen (2) Schnittstellen zum Einrichten einer oder mehrerer drahtloser oder drahtgebundener Verbindungen zwischen der digitalen Plattform (1) und den Sensoren oder Messvorrichtungen (2) umfassen, wobei Datenverknüpfungen mittels der drahtlosen oder drahtgebundenen Verbindungen zwischen der digitalen Plattform (1) und den Sensoren oder Messvorrichtungen (2) einstellbar sind, die dem technischen System (3) der realen Welt zugeordnet sind, das die exogenen und endogenen Parameter, die von den Sensoren oder Messvorrichtungen (2) gemessen und/oder aufgenommen werden, an die digitale Plattform (1) überträgt.

19. Digitale Plattform (1) für Avatar-Messungen sich entwickelnder Messparameter der realen Welt nach einem der Ansprüche 11 bis 18,
**dadurch gekennzeichnet, dass** die digitale Plattform (1) ein automatisiertes Expertensystem der digitalen Plattform (1) umfasst und mittels elektronischem Signaltransfer auslöst, wobei die digitale Plattform (1) die Übertragung einer digitalen Empfehlung an eine Benutzeroberfläche auslöst, von dem Expertensystem der digitalen Plattform basierend auf dem gemessenen Wert des Maßes für einen zukünftigen Zustand oder Betrieb des mit einem Zwilling versehenen technischen System (3) der realen Welt und/oder der gemessenen Wahrscheinlichkeit des Auftretens eines vordefinierten physischen Ereignisses an dem technischen System (3) der realen Welt erzeugt wird, und wobei die digitale Empfehlung Angaben für eine Optimierung des technischen Systems (3) der realen Welt oder Anpassung der Struktur-, Betriebs- und/oder Umgebungszustandsparameter umfasst.

## Revendications

1. Procédé pour une plateforme numérique (1) destinée à la mesure par avatar de paramètres de mesure du monde réel, fondés sur le risque et évoluant au fil du temps, la plateforme numérique (1) comprenant des capteurs de mesure (2) associés à un système technique physique spécifique du monde réel (3), incluant des installations industrielles dotées de systèmes électromécaniques, des moteurs d'aéronef ou des usines de minoterie devant être surveillés, dans lequel la plateforme numérique (1) comprend un magasin de données (10) contenant des éléments de données d'objets numériques modulaires (101, ..., 105) représentant chacun des sous-systèmes (41) du système technique du monde réel (3) pour l'assemblage d'une représentation sous forme de jumeau numérique (4) du système technique physique du monde réel (3) et dans lequel les éléments de données d'objets numériques modulaires (101, ..., 105) sont sélectionnés et assemblés pour former ladite représentation sous forme de jumeau numérique (4) à partir du magasin de données (10) sur la base de paramètres de propriétés (42) structurelles (421), opérationnelles (422) et environnementales (423) capturés au moyen de la plateforme numérique (1), dans lequel
au moyen des capteurs (2) associés au système technique physique jumelé (3), des paramètres d'état (43) structurels (431), opérationnels (432) et environnementaux (433) du système technique du monde réel (3) sont mesurés, surveillés et transmis à la plateforme numérique (1), dans lequel les capteurs (2) comprennent un ou plusieurs capteurs extéroceptifs associés (2) pour détecter des paramètres environnementaux exogènes ayant un impact physique sur le système technique du monde réel (3) et un ou plusieurs capteurs proprioceptifs (2) pour détecter des paramètres de fonctionnement endogènes du système technique du monde réel (3), dans lequel une ou plusieurs connexions sans fil sont établies par des interfaces des capteurs (2) entre la plateforme numérique (1) et les capteurs (2), dans lequel des liaisons de données sont établies au moyen des connexions sans fil entre la plateforme numérique (1) et les capteurs (2) pour transmettre les paramètres d'état (43) mesurés par les capteurs (2) à la plateforme numérique (1), dans lequel les paramètres d'état mesurés (43) sont attribués à la représentation sous forme de jumeau numérique (4), les valeurs des paramètres d'état (43) associées à la représentation sous forme de jumeau numérique (4) étant surveillées et adaptées dynamiquement sur la base des paramètres transmis (43) et dans lequel la représentation sous forme de jumeau numérique (4) comprend des structures de données (44) représentant des états (441) de chacun de la pluralité de sous-systèmes (41) du système technique du monde réel (3), conservant les valeurs des paramètres d'état (43) sous forme de séries temporelles couvrant une période temporelle,
en ce que, au moyen de la plateforme numérique (1), des structures de données (44) pour la représentation sous forme de jumeau numérique (4), représentant des états futurs (441) de chacun de la pluralité de sous-systèmes (41) du système technique du monde réel (3), sont générées sous forme de séries temporelles de valeurs couvrant une période future, sur la base d'une application de simulations utilisant un traitement de modélisation de dommages cumulés, la modélisation de dommages cumulés générant l'effet des paramètres d'état opérationnels et environnementaux de l'objet (43) sur le système technique du monde réel (3) jumelé pour la période future,
en ce que, au moyen de la plateforme numérique (1), la représentation sous forme de jumeau numérique (4) est analysée pour fournir une mesure relative à un état futur du système technique du monde réel (3) jumelé, sur la base des séries temporelles de valeurs générées pour ladite période future, la mesure étant liée à la probabilité de la survenue d'un événement physique prédéfini, d'une certaine intensité ou caractéristique physique, ayant un impact physique sur le système technique du monde réel (3), dans lequel la mesure de probabilité physiquement quantifiable de la survenue de l'événement physique prédéfini est établie sur la base de la fréquence et de la gravité de données de mesure historiques de l'événement physique prédéfini, au moyen d'un module d'apprentissage automatique prédictif utilisant les séries temporelles mesurées des valeurs de paramètres d'état (43),
en ce que, pour générer la probabilité de la survenue d'un événement physique prédéfini ayant un impact sur le système technique du monde réel (3), une modélisation de dommages cumulés est effectuée par le module d'apprentissage automatique, comprenant une première étape de détection de premiers effets anormaux ou significatifs à l'intérieur des séries temporelles générées et mesurées de valeurs de paramètres, dans lequel la détection d'anomalies et d'événements significatifs est déclenchée par le dépassement d'un écart mesuré par rapport à une valeur seuil définie pour un paramètre ou un ensemble de paramètres opérationnels et environnementaux de l'objet et comprenant une deuxième étape de détection d'une deuxième anomalie et d'événements significatifs sur la base des séries temporelles générées et mesurées de valeurs de paramètres, dans lequel, au moyen d'une normalisation temporelle dynamique, une distance topologique entre les séries temporelles mesurées des valeurs de paramètres (43) au fil du temps est déterminée sous forme d'une matrice de distances, dans lequel un signal de série temporelle mesurée des taux d'événements détectés est mis en correspondance, sous forme de tuples de valeurs spectrales ou cepstrales, avec d'autres tuples de valeurs d'un signal de série temporelle mesurée de taux d'événements et dans lequel, en utilisant une pondération pour les paramètres individuels (43) de chaque tuple de valeurs mesurées, une mesure de différence entre deux valeurs quelconques des deux signaux est établie, la plateforme numérique (1) recherchant un trajet optimal du début à la fin des deux signaux via la matrice de distances couverte, représentant les distances deux à deux entre tous les points des deux signaux et
en ce que une commande d'un fonctionnement ou d'un état du système technique du monde réel (3) est optimisée ou ajustée par rapport à des paramètres d'objet de fonctionnement et/ou d'état prédéfinis (43) du système technique du monde réel (3) spécifique, sur la base de la mesure fournie pour un état futur du système technique du monde réel (3) jumelé, dans lequel, dans le cas d'une commande de fonctionnement optimisée ou ajustée, la commande de fonctionnement optimisée est optimisée ou ajustée de manière à augmenter conjointement et solidairement les critères de performance opérationnelle spécifiques, actuels et futurs, du système technique du monde réel (3) ou à réduire une mesure d'une probabilité de survenue associée à l'état du système technique du monde réel (3) dans une plage de probabilité spécifiée.

2. Procédé pour une plateforme numérique (1) destinée à la mesure par avatar de paramètres de mesure du monde réel évoluant au fil du temps selon la revendication 1,
**caractérisé en ce que** la réduction de la mesure de probabilité de survenue associée au fonctionnement ou à l'état du système technique du monde réel (3) repose sur un transfert de risque vers un système de transfert de risque automatisé commandé par la plateforme numérique, dans lequel les valeurs des paramètres caractérisant le transfert de risque sont optimisées sur la base de ladite mesure pour un état ou un fonctionnement futur du système technique du monde réel (3) jumelé et/ou sur la base des séries temporelles de valeurs générées pour ladite période future.

3. Procédé pour une plateforme numérique (1) destinée à la mesure par avatar de paramètres de mesure du monde réel évoluant au fil du temps selon la revendication 1,
**caractérisé en ce que**, afin d'optimiser l'état du système technique du monde réel (3) ou la probabilité d'une survenue d'un événement à risque prédéfini, un ajustement d'optimisation d'au moins un sous-système (34) du système technique du monde réel (3) est déclenché au moyen de la plateforme numérique (1).

4. Procédé pour une plateforme numérique (1) destinée à la mesure par avatar de paramètres de mesure du monde réel évoluant au fil du temps selon la revendication 3,
**caractérisé en ce que** le déclenchement au moyen de la plateforme numérique (1) est effectué par transfert de signal électronique.

5. Procédé pour une plateforme numérique (1) destinée à la mesure par avatar de paramètres de mesure du monde réel évoluant au fil du temps selon une des revendications 1 à 4,
**caractérisé en ce que**, sur la base de la mesure pour un état ou un fonctionnement futur du système technique du monde réel (3) jumelé, une mesure prévisionnelle d'une probabilité de survenue d'un ou plusieurs événements à risque prédéfinis ayant un impact sur le système technique du monde réel (3) est générée par propagation des paramètres de la représentation sous forme de jumeau numérique (4) dans des séries temporelles contrôlées.

6. Procédé pour une plateforme numérique (1) destinée à la mesure par avatar de paramètres de mesure du monde réel évoluant au fil du temps selon la revendication selon une des revendications 1 à 5,
**caractérisé en ce que** les paramètres opérationnels et/ou environnementaux comprennent des paramètres endogènes, dont les valeurs sont déterminées par le système technique du monde réel (3) et/ou des paramètres exogènes, dont les valeurs proviennent de et sont déterminées à l'extérieur du système technique du monde réel (3) et sont imposées au système technique du monde réel (3).

7. Procédé pour une plateforme numérique (1) destinée à la mesure par avatar de paramètres de mesure du monde réel évoluant au fil du temps selon la revendication 6,
**caractérisé en ce que** la plateforme numérique (1) comprend des capteurs ou dispositifs de mesure extéroceptifs associés (2) pour détecter des paramètres environnementaux exogènes ayant un impact physique sur le système technique du monde réel (3) et des capteurs ou dispositifs de mesure proprioceptifs (2) pour détecter des paramètres endogènes de fonctionnement ou d'état du système technique du monde réel (3).

8. Procédé pour une plateforme numérique (1) destinée à la mesure par avatar de paramètres de mesure du monde réel évoluant au fil du temps selon une des revendications 6 ou 7,
**caractérisé en ce que** les capteurs ou dispositifs de mesure (2) comprennent des interfaces pour établir une ou plusieurs connexions sans fil ou filaires entre la plateforme numérique (1) et les capteurs ou dispositifs de mesure (2), des liaisons de données pouvant être établies au moyen des connexions sans fil ou filaires entre la plateforme numérique (1) et les capteurs ou dispositifs de mesure (2) associés au système technique du monde réel (3), transmettant à la plateforme numérique (1) les paramètres exogènes et endogènes mesurés et/ou capturés par les capteurs ou dispositifs de mesure (2).

9. Procédé pour une plateforme numérique (1) destinée à la mesure par avatar de paramètres de mesure du monde réel évoluant au fil du temps selon la revendication selon une des revendications 1 à 8,
**caractérisé en ce que** la plateforme numérique comprend et déclenche un système expert automatisé de la plateforme numérique (1) au moyen d'un transfert de signal électronique, dans lequel la plateforme numérique (1) déclenche la transmission d'une recommandation numérique vers une interface d'utilisateur générée par le système expert de la plateforme numérique, sur la base de la valeur mesurée de la mesure pour un état ou un fonctionnement futur du système technique du monde réel jumelé (3) et/ou de la probabilité mesurée de la survenue d'un événement physique prédéfini pour le système technique du monde réel (3) et dans lequel la recommandation numérique comprend des indications pour une optimisation du système technique du monde réel (3) ou pour l'adoption de paramètres d'état structurels, opérationnels et/ou environnementaux.

10. Procédé pour une plateforme numérique (1) destinée à la mesure par avatar de paramètres de mesure du monde réel évoluant au fil du temps selon une des revendications 1 à 9,
**caractérisé en ce que** le procédé comprend les étapes supplémentaires consistant à mesurer des écarts de paramètres relatifs, donnés par l'écart mesuré d'une valeur moyenne sur une unité de temps des paramètres de mesure, par paramètre ou ensemble de paramètres d'un élément de jumeau numérique par rapport à une valeur de paramètre cible ; mesurer des distributions de fréquences associées des écarts de mesure relatifs mis à l'échelle par paramètre ou ensemble de paramètres d'un élément de jumeau numérique ; mesurer des taux au fil du temps par élément du jumeau numérique sous forme de série temporelle de valeurs de taux mesurées ; et mesurer des vitesses d'intervalles de temps en fonction du temps par élément du jumeau numérique.

11. Plateforme numérique (1) destinée à la mesure par avatar de paramètres de mesure du monde réel, fondés sur le risque et évoluant au fil du temps, la plateforme numérique (1) comprenant des moyens de mesure (2) associés à un système technique du monde réel physique spécifique (3), incluant des installations industrielles dotées de systèmes électromécaniques, des moteurs d'aéronefs ou des usines de minoterie devant être surveillés, dans lequel la plateforme numérique (1) comprend un magasin de données (10) stockant des éléments de données d'objets numériques modulaires (101, ..., 105) représentant chacun des sous-systèmes (14) du système technique du monde réel (3) pour l'assemblage d'une représentation sous forme de jumeau numérique (4) du système technique du monde réel (3) et dans lequel les éléments de données d'objets numériques modulaires (101, ..., 105) peuvent être sélectionnés pour être assemblés à ladite représentation sous forme de jumeau numérique (4) à partir du magasin de données (10) sur la base de paramètres de propriétés (42) structurelles (421), opérationnelles (422) et environnementales (423) capturés au moyen de la plateforme numérique (1), dans laquelle
les capteurs (2) associés au système technique physique jumelé (3) sont configurés pour mesurer, surveiller et transmettre des paramètres d'état (43) structurels (431), opérationnels (432) et environnementaux (433) du système technique du monde réel (3) à la plateforme numérique (1) afin qu'ils soient associés à la représentation sous forme de jumeau numérique (4), dans lequel les capteurs (2) comprennent un ou plusieurs capteurs extéroceptifs associés (2) pour détecter des paramètres environnementaux exogènes ayant un impact physique sur le système technique du monde réel (3) et un ou plusieurs capteurs proprioceptifs (2) pour détecter des paramètres de fonctionnement endogènes du système technique du monde réel (3), dans lequel les capteurs ou dispositifs de mesure (2) comprennent des interfaces pour établir une ou plusieurs connexions sans fil entre la plateforme numérique (1) et les capteurs (2), dans lequel les connexions sans fil entre la plateforme numérique (1) et les capteurs (2) sont configurées pour établir des liaisons de données associées au système technique du monde réel (3) transmettant les paramètres d'état (43) mesurés par les capteurs (2) à la plateforme numérique (1), dans lequel les valeurs des paramètres d'état mesurés (43) associés à la représentation sous forme de jumeau numérique (4) sont surveillées et adaptées dynamiquement sur la base des paramètres transmis (43) et dans lequel la représentation sous forme de jumeau numérique (4) comprend des structures de données (44) représentant des états (441) de chacun de la pluralité de sous-systèmes (41) du système technique du monde réel (3) contenant les valeurs des paramètres d'état (43) sous forme de séries temporelles sur une période temporelle,
en ce que la plateforme numérique (1) est configurée pour générer des structures de données (44) pour la représentation sous forme de jumeau numérique (4) représentant des états futurs (441) de chacun de la pluralité de sous-systèmes (41) du système technique du monde réel (3) sous forme de séries temporelles de valeurs sur une période future, sur la base de l'application de simulations utilisant des modèles de dommages cumulés, les modèles de dommages cumulés générant l'effet des paramètres d'état opérationnels et environnementaux (43) sur le système technique du monde réel (3) jumelé pour la période future,
en ce que la plateforme numérique (1) est configurée pour analyser la représentation sous forme de jumeau numérique (4) en fournissant une mesure pour un état futur du système technique du monde réel (3) jumelé sur la base des séries temporelles de valeurs générées sur ladite période future, la mesure étant liée à la probabilité de la survenue d'un événement physique prédéfini, d'une certaine intensité ou caractéristique physique, ayant un impact physique sur le système technique du monde réel (3), dans lequel la mesure de probabilité physiquement mesurable de survenue ou de développement de l'événement physique prédéfini est établie sur la base de la fréquence et de la gravité de données de mesure historiques relatives à l'événement physique prédéfini, au moyen d'un module d'apprentissage automatique prédictif utilisant les séries temporelles mesurées de valeurs de paramètres d'état (43),
en ce que, pour générer la probabilité de la survenue d'un événement physique prédéfini ayant un impact sur le système technique du monde réel (3), une modélisation des dommages cumulés est effectuée par le module d'apprentissage automatique, comprenant une première étape de détection de premiers effets anormaux ou significatifs à l'intérieur des séries temporelles générées et mesurées de valeurs de paramètres, dans lequel la détection d'anomalies et d'événements significatifs est déclenchée par le dépassement d'un écart mesuré par rapport à une valeur seuil définie pour un paramètre ou un ensemble de paramètres opérationnels et environnementaux de l'objet et comprenant une deuxième étape de détection d'une deuxième anomalie et d'événements significatifs sur la base des séries temporelles générées et mesurées de valeurs de paramètres, dans lequel, au moyen d'une normalisation temporelle dynamique, une distance topologique entre les séries temporelles mesurées des valeurs de paramètres (43) au fil du temps est déterminée sous forme d'une matrice de distances, dans lequel un signal de série temporelle mesurée des taux d'événements détectés est mis en correspondance, sous forme de tuples de valeurs spectrales ou cepstrales, avec d'autres tuples de valeurs d'un signal de série temporelle mesurée de taux d'événements et dans lequel, en utilisant une pondération pour les paramètres individuels (43) de chaque tuple de valeurs mesurées, une mesure de différence entre deux valeurs quelconques des deux signaux est établie, la plateforme numérique (1) recherchant un trajet optimal du début à la fin des deux signaux via la matrice de distances couverte, représentant les distances deux à deux entre tous les points des deux signaux et
en ce que une commande d'un fonctionnement ou d'un état du système technique du monde réel (3) est optimisée ou ajustée par rapport à des paramètres d'objet de fonctionnement et/ou d'état prédéfinis du système technique du monde réel (3) spécifique, sur la base de la mesure fournie pour un état futur du système technique du monde réel (3) jumelé, dans lequel, dans le cas d'une commande de fonctionnement optimisée ou ajustée, la commande de fonctionnement optimisée est générée de manière à augmenter conjointement et solidairement les critères de performance opérationnelle spécifiques, actuels et futurs, du système technique du monde réel (3) ou à réduire une mesure d'une probabilité de survenue associée à l'état du système technique du monde réel (3) dans une plage de probabilité spécifiée.

12. Plateforme numérique (1) destinée à la mesure par avatar de paramètres de mesure du monde réel, fondés sur le risque et évoluant au fil du temps selon la revendication 11,
**caractérisée en ce que** la réduction de la mesure d'une probabilité de survenue associée au fonctionnement ou à l'état du système technique du monde réel (3) repose sur un transfert de risque vers un système automatisé de transfert de risque commandé par la plateforme numérique, dans laquelle les valeurs des paramètres caractérisant le transfert de risque sont optimisées sur la base de ladite mesure pour un état ou un fonctionnement futur du système technique du monde réel (3) jumelé et/ou sur la base des séries temporelles de valeurs générées pour ladite période future.

13. Plateforme numérique (1) destinée à la mesure par avatar de paramètres de mesure du monde réel, fondés sur le risque et évoluant au fil du temps selon la revendication 11,
**caractérisée en ce que**, afin d'optimiser l'état du système technique du monde réel (3) ou la probabilité d'une survenue d'un événement de risque prédéfini, un ajustement d'optimisation d'au moins un sous-système (34) du système technique du monde réel (3) est déclenché au moyen de la plateforme numérique (1).

14. Plateforme numérique (1) destinée à la mesure par avatar de paramètres de mesure du monde réel, fondés sur le risque et évoluant au fil du temps selon la revendication 13,
**caractérisée en ce que** le déclenchement au moyen de la plateforme numérique (1) est effectué par transfert de signal électronique.

15. Plateforme numérique (1) destinée à la mesure par avatar de paramètres de mesure du monde réel, fondés sur le risque et évoluant au fil du temps selon une des revendications 11 à 14,
**caractérisée en ce que**, sur la base de la mesure pour un état ou un fonctionnement futur du système technique du monde réel (3) jumelé, une mesure prévisionnelle d'une probabilité de survenue d'un ou plusieurs événements de risque prédéfinis ayant un impact sur le système technique du monde réel (3) est générée par propagation des paramètres de la représentation sous forme de jumeau numérique (2) dans des séries temporelles contrôlées.

16. Plateforme numérique (1) destinée à la mesure par avatar de paramètres de mesure du monde réel, fondés sur le risque et évoluant au fil du temps selon une des revendications 11 à 15,
**caractérisée en ce que** les paramètres opérationnels et/ou environnementaux comprennent des paramètres endogènes, dont les valeurs sont déterminées par le système technique du monde réel (3) et/ou des paramètres exogènes, dont les valeurs proviennent de l'extérieur du système technique du monde réel (3), sont déterminées à l'extérieur de celui-ci et sont imposées au système technique du monde réel (3).

17. Plateforme numérique (1) destinée à la mesure par avatar de paramètres de mesure du monde réel, fondés sur le risque et évoluant au fil du temps selon la revendication 16,
**caractérisée en ce que** la plateforme numérique comprend des capteurs ou dispositifs de mesure extéroceptifs associés (2) pour détecter des paramètres environnementaux exogènes ayant un impact physique sur le système technique du monde réel (3) et des capteurs ou dispositifs de mesure proprioceptifs (2) pour détecter des paramètres endogènes de fonctionnement ou d'état du système technique du monde réel (3).

18. Plateforme numérique (1) destinée à la mesure par avatar de paramètres de mesure du monde réel, fondés sur le risque et évoluant au fil du temps selon une des revendications 16 ou 17,
**caractérisée en ce que** les capteurs ou dispositifs de mesure (2) comprennent des interfaces pour établir une ou plusieurs connexions sans fil ou filaires entre la plateforme numérique (1) et les capteurs ou dispositifs de mesure (2), dans lequel des liaisons de données peuvent être établies au moyen des connexions sans fil ou filaires entre la plateforme numérique (1) et les capteurs ou dispositifs de mesure (2) associés au système technique du monde réel (3), transmettant les paramètres exogènes et endogènes mesurés et/ou captés par les capteurs ou dispositifs de mesure (2) vers la plateforme numérique (1).

19. Plateforme numérique (1) destinée à la mesure par avatar de paramètres de mesure du monde réel, fondés sur le risque et évoluant au fil du temps selon une des revendications 11 à 18,
**caractérisée en ce que** la plateforme numérique (1) comprend et déclenche un système expert automatisé de la plateforme numérique (1) au moyen d'un transfert de signal électronique, dans lequel la plateforme numérique (1) déclenche la transmission d'une recommandation numérique vers une interface d'utilisateur générée par le système expert de la plateforme numérique, sur la base de la valeur mesurée de la mesure d'un état ou un fonctionnement futur du système technique du monde réel (3) jumelé et/ou de la probabilité mesurée de la survenue d'un événement physique prédéfini concernant le système technique du monde réel (3) et dans laquelle la recommandation numérique comprend des indications pour une optimisation du système technique du monde réel (3) ou pour l'adoption de paramètres d'état structurels, opérationnels et/ou environnementaux.
